# EUROPEAN PATENT APPLICATION

(11) **EP 4 567 505 A1**
(43) Date of publication of application: **11.06.2025**
(21) Application number: 24215628.9
(22) Date of filing: 27.11.2024
(51) Int. Cl.: G02F 1/1333, H05K 7/14

(54) **DISPLAY DEVICE**

(30) Priority: 08.12.2023 KR 20230177427
(71) Applicant: LG Electronics Inc., Yeongdeungpo-gu Seoul 07336 (KR)
(72) Inventor: KIM, Munhwan, 06772 Seoul (KR); LEE, Kyungji, 06772 Seoul (KR)
(74) Representative: Vossius & Partner Patentanwälte Rechtsanwälte mbB

(57) **Abstract**

A display device is disclosed. The display device may include: a display panel; a frame located behind the display panel; and a substrate located behind the frame and having a hole, wherein the frame may include: a depressed portion protruding from the frame toward the substrate and on which the substrate is located; and a contact portion protruding from the depressed portion and inserted into the hole, wherein a part of the contact portion may be located on a rear surface of the substrate.

## Description

### CROSS-REFERENCE TO RELATED APPLICATION

This application claims the priority benefit of Korean Patent Application No. 10-2023-0177427, filed on December 8, 2023.

### BACKGROUND OF THE INVENTION

### Field of the invention

The present disclosure relates to a display device.

### Description of the Related Art

With the advent of the information society, various demands for display devices are increasing. Various display devices, such as liquid crystal display (LCD) devices, plasma display panel (PDP) devices, electroluminescent display (ELD) devices, vacuum fluorescent display (VFD) devices, and organic light-emitting diode (OLED) devices, have recently been studied and used to meet various demands for display devices.

Thereamong, an LCD panel includes a thin-film transistor (TFT) substrate and a color substrate, which are disposed opposite each other with a liquid crystal layer interposed therebetween, and may display an image using light provided from a backlight unit. An OLED panel may display an image by depositing an organic layer having a self-emission structure on a substrate having a transparent electrode formed thereon.

Recently, studies have been actively conducted on improvement in an assembly structure of display devices.

### SUMMARY OF THE INVENTION

It is an object of the present disclosure to solve the above and other problems.

Another object of the present disclosure may be to provide a coupling structure between a frame and a substrate.

Another object of the present disclosure may be to provide a structure allowing the substrate to be stably coupled to the frame without a separate fastening member such as a screw.

Another object of the present disclosure may be to provide a structure for ensuring contact point stability between the substrate and the frame.

Another object of the present disclosure may be to provide various examples of a coupling structure between the substrate and the frame.

In accordance with an aspect of the present disclosure for achieving the above and other objects, a display device may include: a display panel; a frame located behind the display panel; and a substrate located behind the frame and having a hole, wherein the frame may include a depressed portion protruding from the frame toward the substrate and on which the substrate is located; and a contact portion protruding from the depressed portion and inserted into the hole, and wherein a part of the contact portion may located on a rear surface of the substrate.

### BRIEF DESCRIPTION OF THE DRAWINGS

The above and other obj ects, features, and other advantages of the present disclosure will be more clearly understood from the following detailed description taken in conjunction with the accompanying drawings, in which:

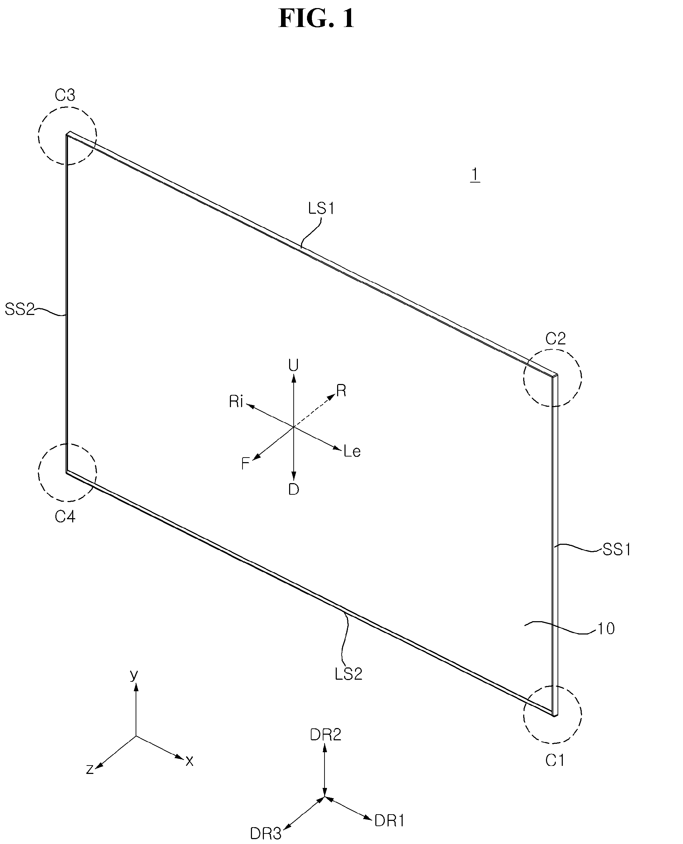

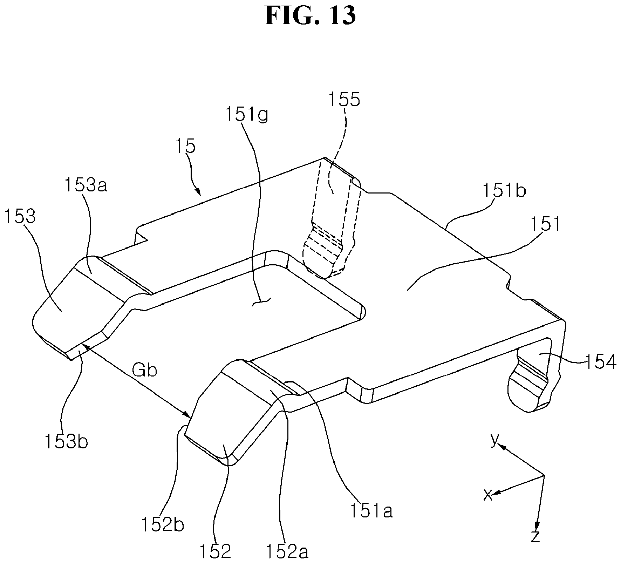

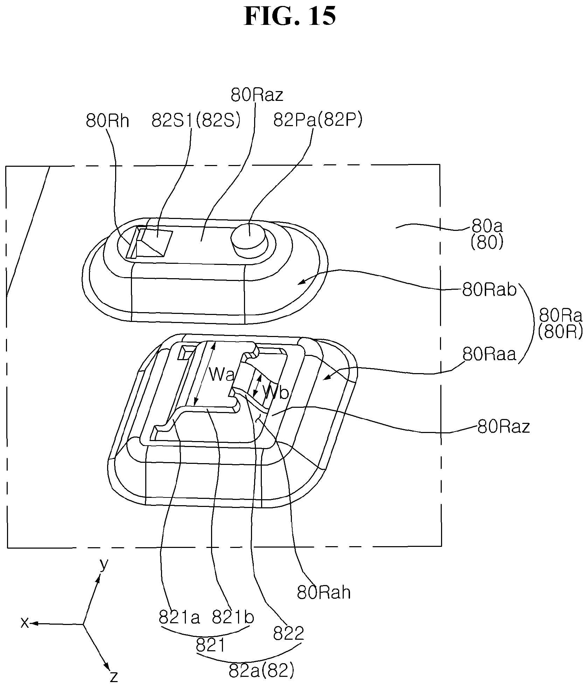

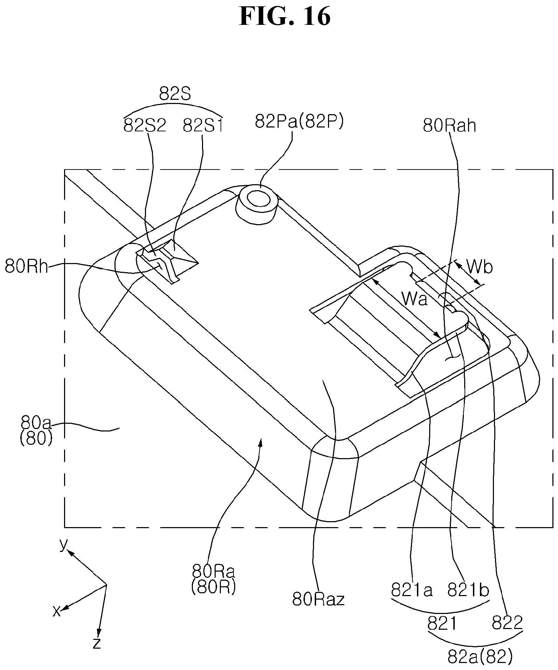

FIGs. 1 to 43 are views showing examples of a display device according to embodiments of the present disclosure.

### DETAILED DESCRIPTION

Hereinafter, the embodiments disclosed in the present specification will be described in detail with reference to the accompanying drawings, and the same or similar elements are denoted by the same reference numerals even though they are depicted in different drawings, and redundant descriptions thereof will be omitted.

In the following description, with respect to constituent elements used in the following description, the suffixes "module" and "unit" are used only in consideration of facilitation of description, and do not have mutually distinguished meanings or functions.

In the following description of the embodiments disclosed in the present specification, a detailed description of known functions and configurations incorporated herein will be omitted when the same may make the subject matter of the embodiments disclosed in the present specification rather unclear. In addition, the accompanying drawings are provided only for a better understanding of the embodiments disclosed in the present specification and are not intended to limit the technical ideas disclosed in the present specification. Therefore, it should be understood that the accompanying drawings include all modifications, equivalents, and substitutions within the scope and sprit of the present invention.

It will be understood that although the terms "first", "second", etc., may be used herein to describe various components, these components should not be limited by these terms. These terms are only used to distinguish one component from another component.

It will be understood that when a component is referred to as being "connected to" or "coupled to" another component, it may be directly connected to or coupled to another component, or intervening components may be present. On the other hand, when a component is referred to as being "directly connected to" or "directly coupled to" another component, there are no intervening components present.

As used herein, the singular form is intended to include the plural forms as well, unless the context clearly indicates otherwise.

It will be further understood that the terms "comprises", "comprising", "includes", and/or "including", when used herein, specify the presence of stated features, integers, steps, operations, elements, components, or combinations thereof, but do not preclude the presence or addition of one or more other features, integers, steps, operations, elements, components, or combinations thereof.

In the embodiments illustrated in the drawings, representations of directions, such as up (U), down (D), left (Le), right (Ri), front (F), and rear (R), are merely for convenience of explanation, and are not intended to limit the technical features disclosed in this specification.

Referring to FIG. 1, a display device 1 may include a display panel 10. The display panel 10 may display an image.

The display device 1 may include a first long side LS1, a second long side LS2 opposite the first long side LS1, a first short side SS1 adjacent to the first and second long sides LS1 and LS2, and a second short side SS2 opposite the first short side SS1. For convenience of explanation, the lengths of the first and second long sides LS1 and LS2 are shown and described as being greater than the lengths of the first and second short sides SS1 and SS2. However, the lengths of the first and second long sides LS1 and LS2 may be set to be approximately equal to the lengths of the first and second short sides SS1 and SS2.

A direction parallel to the long sides LS1 and LS2 of the display device 1 may be referred to as a leftward-rightward direction or a first direction DR1. The first short side SS1 may be referred to as a left side Le or x, and the second short side SS2 may be referred to as a right side Ri.

A direction parallel to the short sides SS1 and SS2 of the display device 1 may be referred to as an upward-downward direction or a second direction DR2. The first long side LS1 may be referred to as an upper side U or y, and the second long side LS2 may be referred to as a lower side D.

A direction perpendicular to the long sides LS1 and LS2 and the short sides SS1 and SS2 of the display device 1 may be referred to as a forward-backward direction or a third direction DR3. A side of the display panel 10 on which an image is displayed may be referred to as a front side F or z, and a side opposite the front side may be referred to as a rear side R.

The first long side LS1, the second long side LS2, the first short side SS1, and the second short side SS2 may be referred to as edges of the display device 1. Points at which the first long side LS1, the second long side LS2, the first short side SS1, and the second short side SS2 meet each other may be referred to as corners. A point at which the second long side LS2 and the first short side SS1 meet each other may be referred to as a first corner C1. A point at which the first short side SS1 and the first long side LS1 meet each other may be referred to as a second corner C2. A point at which the first long side LS1 and the second short side SS2 meet each other may be referred to as a third corner C3. A point at which the second short side SS2 and the second long side LS2 meet each other may be referred to as a fourth corner C4.

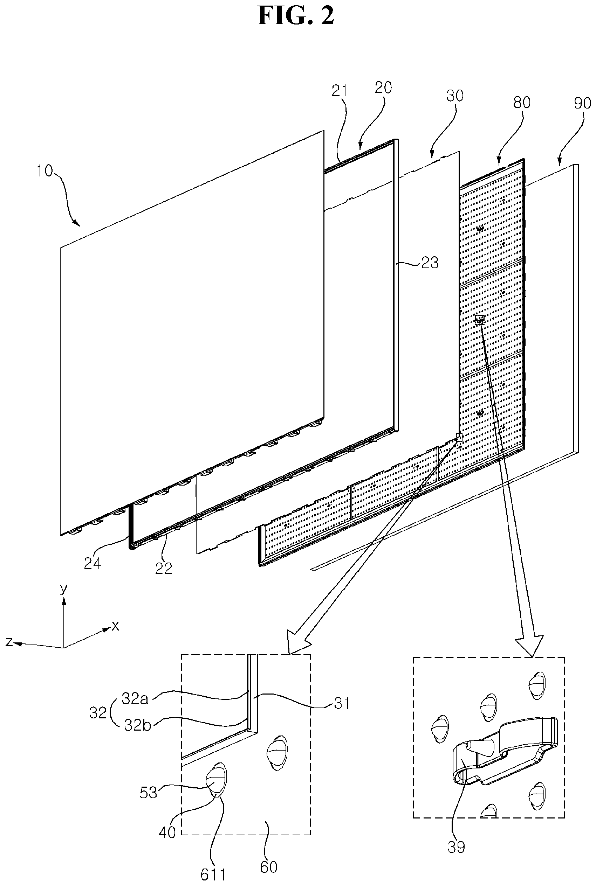

Referring to FIGs. 1 and 2, the display device 1 may include a display panel 10, a side frame 20, a backlight unit, a frame 80, and a back cover 90.

The display panel 10 may define the front surface of the display device 1 and may display an image. The display panel 10 may display an image in such a manner that each of a plurality of pixels outputs red, green, or blue (RGB) light according to a predetermined timing. The display panel 10 may be divided into an active area in which an image is displayed and a de-active area in which an image is not displayed. The display panel 10 may include a front substrate and a rear substrate, which are disposed opposite each other with a liquid crystal layer interposed therebetween. The display panel 10 may be referred to as an LCD panel 10. Alternatively, the display panel 10 may be another type of panel, such as an OLED panel. In this case, the backlight unit, which will be described later, may be omitted.

The front substrate may include a plurality of pixels composed of red, green, and blue sub-pixels. The front substrate may output red light, green light, or blue light in response to a control signal.

The rear substrate may include switching elements. The rear substrate may switch a pixel electrode. For example, the pixel electrode may change the molecular arrangement of the liquid crystal layer in response to a control signal input thereto from the outside. The liquid crystal layer may include liquid crystal molecules. The arrangement of the liquid crystal molecules may change according to a voltage difference generated between the pixel electrode and a common electrode. The liquid crystal layer may allow or interrupt the transmission of light from the backlight unit to the front substrate.

The side frame 20 may extend along the edge of the display panel 10. The side frame 20 may cover the edge of the display panel 10. For example, the side frame 20 may include plastic or metal. The side frame 20 may be referred to as a guide panel 20.

The backlight unit may be located behind the display panel 10. The backlight unit may be located in front of the frame 80 and may be coupled to the frame 80. The backlight unit may be driven in a fully driven manner or a partially driven manner such as local dimming or impulsive driving. The backlight unit may include light sources providing light forward, a substrate 40 on which the light sources are mounted, lenses 53 covering the light sources, a reflective sheet 60 covering the front surface of the substrate 40, and an optical unit 30 located in front of the reflective sheet 60.

The optical unit 30 may be disposed opposite the display panel 10 with respect to the side frame 20. The optical unit 30 may evenly transmit light from the light source to the display panel 10. The optical unit 30 may include a diffusion plate 31 and an optical sheet 32.

The diffusion plate 31 may be located between the reflective sheet 60 and the optical sheet 32. The diffusion plate 31 may diffuse light from the light source. In addition, an air gap may be formed between the reflective sheet 60 and the diffusion plate 31. The air gap may function as a buffer, and the light from the light source may be widely spread by the air gap. A support 39 may be located between the reflective sheet 60 and the diffusion plate 31, may be coupled to the reflective sheet 60, and may support the diffusion plate 31.

The optical sheet 32 may be adjacent to or in contact with the front surface of the diffusion plate 31. The optical sheet 32 may include at least one sheet. For example, the optical sheet 32 may include a plurality of sheets having different functions, and the plurality of sheets may be adhered to or in close contact with each other. For example, the first optical sheet 32a may be a diffusion sheet, and the second optical sheet 32b may be a prism sheet. The diffusion sheet may prevent light emitted from the diffusion plate 31 from being partially concentrated, thereby making light distribution uniform. The prism sheet may collect light emitted from the diffusion sheet, and may provide the collected light to the display panel 10. The number and/or position of diffusion sheets and prism sheets may vary.

For example, the optical sheet 32 may change the wavelength or color of light provided from the light source. For example, the optical sheet 32 may include a red-based phosphor and/or a green-based phosphor. In this case, the light source may provide blue-based light, and the optical sheet 32 may convert the light from the light source into white light. The optical sheet 32 may be referred to as a quantum dot (QD) sheet.

The frame 80 may be located behind the backlight unit. The display panel 10, the side frame 20, and the backlight unit may be coupled to the frame 80. The frame 80 may support the components of the display device described above and to be described later. For example, the frame 80 may include metal such as an aluminum alloy. The frame 80 may be referred to as a main frame 80, a module cover 80, or a cover bottom 80.

The back cover 90 may cover the rear side of the frame 80 and may be coupled to the frame 80. For example, the back cover 90 may be an injection-molded product made of resin. In another example, the back cover 90 may include metal.

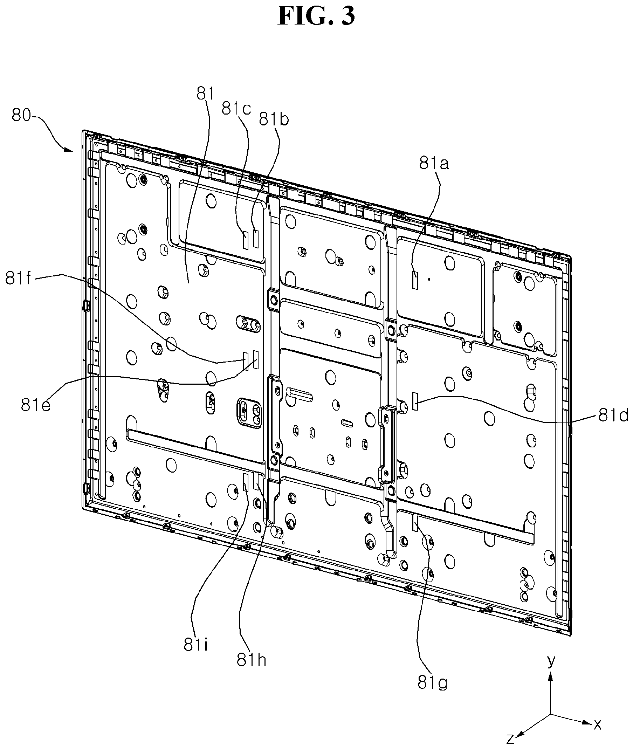

Referring to FIG. 3, a flat plate portion 81 may define the front surface of the frame 80. A plurality of frame holes 81a, 81b, 81c, 81d, 81e, 81f, 81g, 81h, and 81i may be formed in the flat plate portion 81.

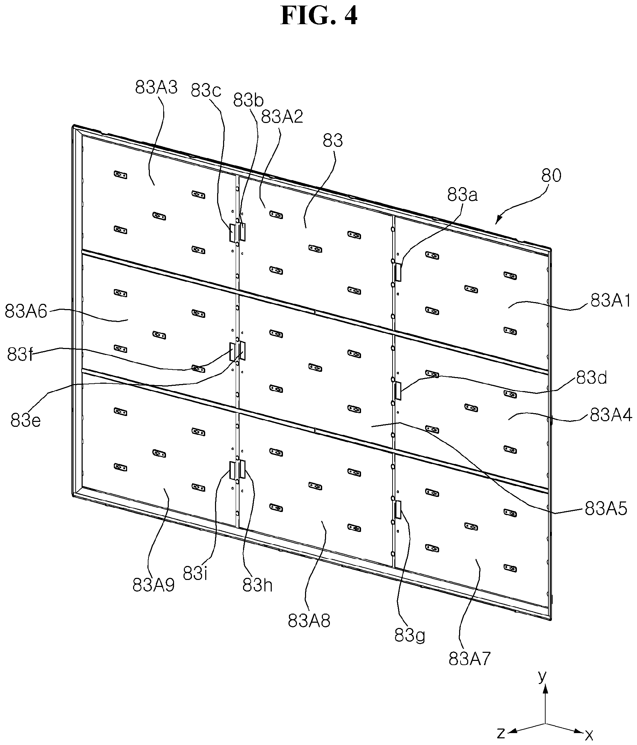

Referring to FIGs. 3 and 4, a heat dissipation plate 83 may cover the front surface of the flat plate portion 81 and may be coupled to the flat plate portion 81. A plurality of heat dissipation plate holes 83a, 83b, 83c, 83d, 83e, 83f, 83g, 83h, and 83i may be formed in the heat dissipation plate 83 and may be aligned with the plurality of frame holes 81a, 81b, 81c, 81d, 81e, 81f, 81g, 81h, and 81i. The heat dissipation plate 83 may be omitted.

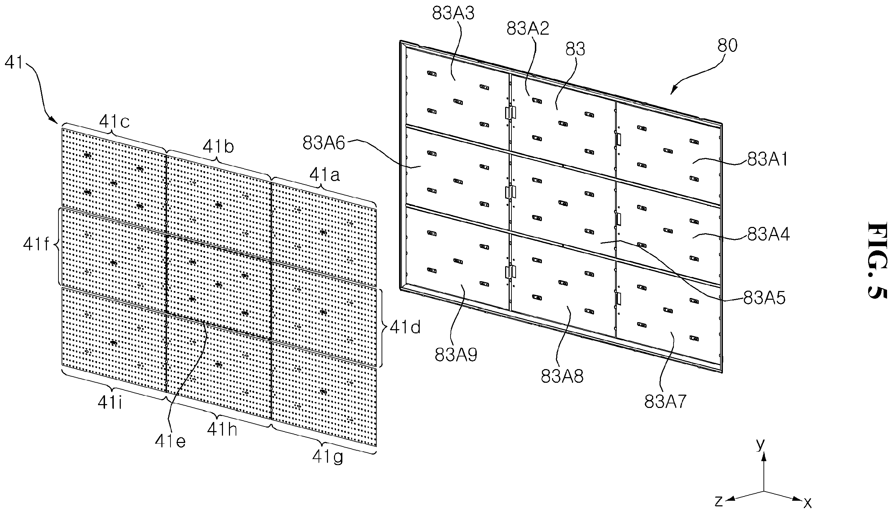

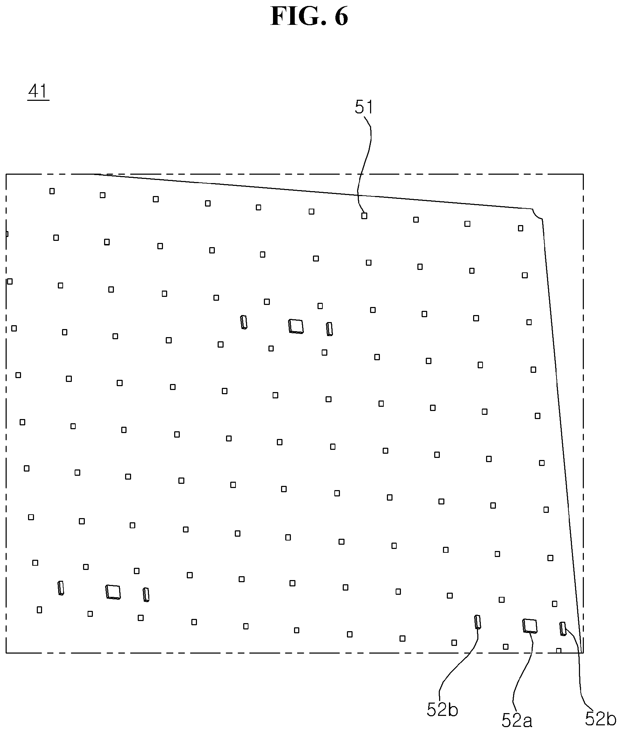

Referring to FIGs. 5 and 6, a substrate 41 may be coupled to the front surface of the frame 80 or the heat dissipation plate 83. The substrate 41 may be a printed circuit board (PCB). For example, the substrate 41 may include at least one of polyethylene terephthalate (PET), glass, polycarbonate (PC), or silicon. The substrate 41 may have a plate shape. Alternatively, the substrate 41 may include a plurality of bars spaced apart from each other or may have a fork shape.

The substrate 41 may include at least one substrate. Each of a plurality of substrates 41a, 41b, 41c, 41d, 41e, 41f, 41g, 41h, and 41i may cover a respective one of a plurality of regions 83A1, 83A2, 83A3, 83A4, 83A5, 83A6, 83A7, 83A8, and 83A9 of the heat dissipation plate 83.

A light source 51 may be mounted on the front surface of the substrate 41. A plurality of light sources 51 may be arranged in a matrix form on the front surface of the substrate 41. The light source 51 may be a light-emitting diode (LED) chip or an LED package. The light source 51 may be implemented as a color LED, which emits at least one of a red color, a green color, or a blue color, or a white LED. The light source 51 may be a mini-LED. An electrode pattern may be formed on the substrate 41 and may connect an adaptor (connector) to the light source 51. A power supply board may supply power to the light source 51 through the substrate 41. For example, the electrode pattern may be a carbon nanotube electrode pattern.

An integrated device 52a and a capacitor 52b may be located around the light source 51 and may be mounted on the front surface of the substrate 41. The integrated device 52a may be an IC chip. A plurality of capacitors 52b may be disposed opposite each other with respect to the integrated device 52a. The integrated device 52a may control power supplied to a predetermined number of light sources 51.

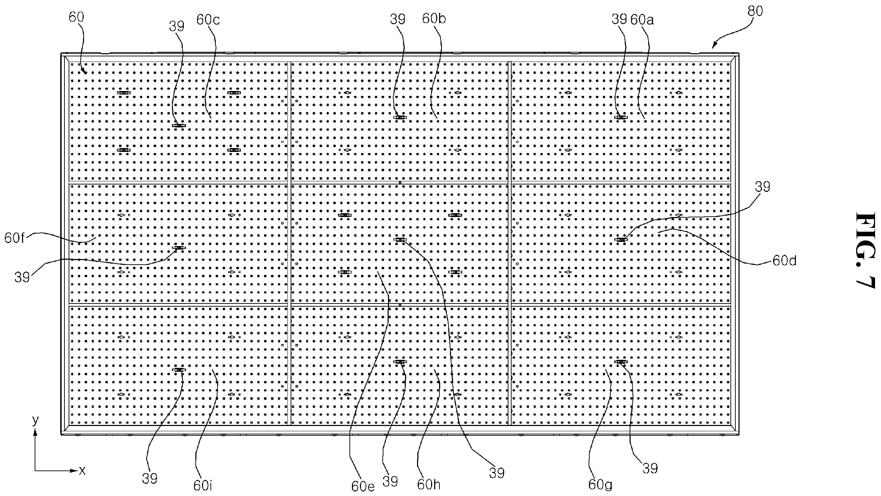

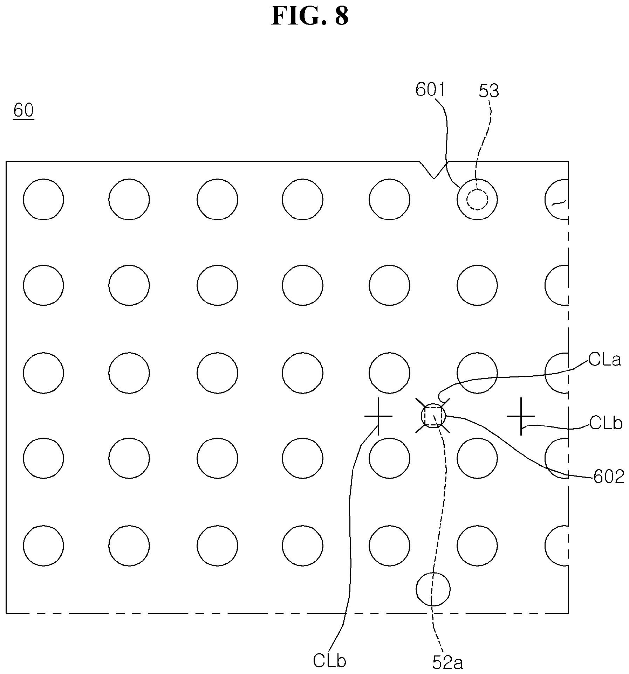

Referring to FIGs. 7 and 8, the reflective sheet 60 may be coupled to the front surface of the substrate 41 (refer to FIG. 5). The reflective sheet 60 may reflect light emitted from the light source 51 or light reflected from the diffusion plate 31 in the forward direction (refer to FIG. 2). For example, the reflective sheet 60 may include highly reflective metal and/or metal oxide such as, for example, at least one of aluminum (Al), silver (Ag), gold (Au), or titanium dioxide (TiO2). For example, resin may be deposited on or applied to the reflective sheet 60. The reflective sheet 60 may include at least one reflective sheet. A plurality of reflective sheets 60a, 60b, 60c, 60d, 60e, 60f, 60g, 60h, and 60i may cover the substrate(s) 41 (refer to FIG. 5).

A hole 601 may be formed in the reflective sheet 60, and the light source 51 (refer to FIG. 6) or the lens 53 covering the light source 51 may be located in the hole 601. The diameter of the hole 601 may be larger than the diameter of the lens 53. The number of holes 601 may be equal to the number of light sources 51 or lenses 53.

A receiving hole 602 may be formed in the reflective sheet 60, and the integrated device 52a (refer to FIG. 6) may be located in the receiving hole 602. A first cut line CLa formed around the receiving hole 602 may be opened by the integrated device 52a. Cross-shaped second cut lines CLb may be formed in the reflective sheet 60 and may be located opposite each other with respect to the first cut line CLa. The capacitors 52b (refer to FIG. 6) may be located in the second cut lines CLb, and the second cut lines CLb may be opened by the capacitors 52b. Accordingly, the reflective sheet 60 may be in close contact with the substrate 41, and thus light uniformity may be improved.

The support 39 may penetrate the reflective sheet 60 and the substrate 41 to be detachably coupled to the heat dissipation plate 83 and/or the frame 80 (refer to FIG. 5). A plurality of supports 39 may be spaced apart from each other and may be disposed on the reflective sheet 60. The front end of the support 39 may support the rear surface of the diffusion plate 31 (refer to Figure 2).

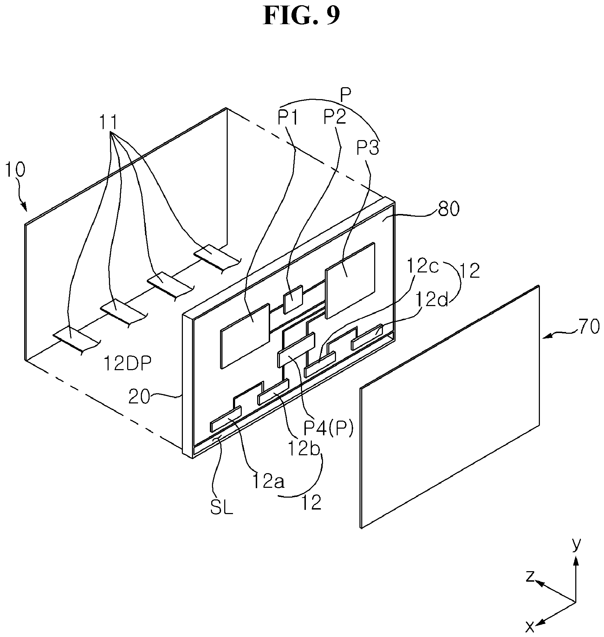

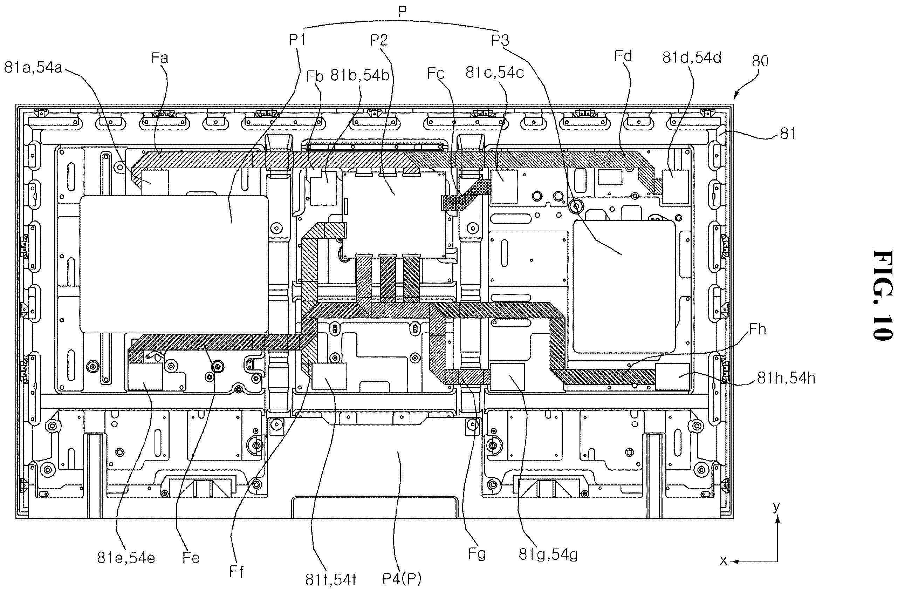

Referring to FIGs. 9 and 10, a board P may be mounted on the frame 80. A plurality of electronic devices may be mounted on the board P. The board P may be a printed circuit board (PCB) and may be electrically connected to electronic components of the display device. The board P may be referred to as a substrate P. A plurality of boards P may be coupled to the rear surface of the frame 80.

A power supply board P1 may supply power to each of the components of the display device. A light-emitting diode (LED) driver P2 may be electrically connected to the power supply board P1 and a main board P3 via a cable (not denoted by a reference numeral) and may supply power and current to the substrate on which the light sources such as LEDs are mounted. The main board P3 may control each of the components of the display device. A timing controller board P4 may be electrically connected to the main board P3 via a cable (not denoted by a reference numeral) and may provide an image signal to the display panel 10. For example, the power supply board P1 may be adjacent to the left side of the frame 80, and the main board P3 may be adjacent to the right side of the frame 80. The LED driver P2 may be located between the power supply board P1 and the main board P3, and the timing controller board P4 may be located below the LED driver P2.

A cable 11 may be adjacent to the lower side of the display panel 10 and may be electrically connected to the display panel 10. The cable 11 may pass through a slit SL or a hole formed in the frame 80. For example, the cable 11 may be a chip-on-film (COF).

A source PCB 12 may be adjacent to the lower side of the frame 80 and may be coupled to the rear surface of the frame 80, and may be electrically connected to the cable 11. For example, a plurality of source PCBs 12a, 12b, 12c, and 12d may be spaced apart from each other along the lower side of the frame 80 and may be electrically connected to a plurality of cables 11. The second source PCB 12b may be electrically connected to the first source PCB 12a via a first bridge cable (not denoted by a reference numeral). The third source PCB 12c may be electrically connected to the fourth source PCB 12d via a second bridge cable (not denoted by a reference numeral). The second source PCB 12b and the third source PCB 12c may be electrically connected to the timing controller board P4 via connecting cables (not denoted by a reference numeral). For example, the first and second bridge cables and the connecting cables may be flexible flat cables (FFCs).

Accordingly, the timing controller board P4 may provide digital video data and a timing control signal to the display panel 10 through the source PCB 12.

The LED driver P2 may be electrically connected to connectors 54a, 54b, 54c, 54d, 54e, 54f, 54g, and 54h via cables Fa, Fb, Fc, Fd, Fe, Ff, Fg, and Fh. The cables Fa, Fb, Fc, Fd, Fe, Ff, Fg, and Fh may be flexible flat cables (FFCs). The connectors 54a, 54b, 54c, 54d, 54e, 54f, 54g, and 54h may be mounted on the rear surfaces of the substrates 41a, 41b, 41c, 41d, 41e, 41f, 41g, and 41h arranged in two rows and four columns. A microcontroller unit (MCU) of the LED driver P2 may convert (process) data on the brightness of the plurality of light sources 51 on the plurality of substrates 41, received from the main board P3, and may provide the converted data to a driver IC of the LED driver P2. The driver IC may be connected to the substrates 41 via the cables Fa, Fb, Fc, Fd, Fe, Ff, Fg, and Fh and the connectors 54a, 54b, 54c, 54d, 54e, 54f, 54g, and 54h, and may control the amount of current flowing through the light sources 51 on each substrate or may interrupt the flow of current, thereby controlling the brightness of the light sources 51.

One end of the first cable Fa may be connected to a first connector of the LED driver P2, and the other end of the first cable Fa may be connected to the first connector 54a through the first frame hole 81a.

One end of the second cable Fb may be connected to a second connector of the LED driver P2, and the other end of the second cable Fb may be connected to the second connector 54b through the second frame hole 81b.

One end of the third cable Fc may be connected to a third connector of the LED driver P2, and the other end of the third cable Fc may be connected to the third connector 54c through the third frame hole 81c.

One end of the fourth cable Fd may be connected to a fourth connector of the LED driver P2, and the other end of the fourth cable Fd may be connected to the fourth connector 54d through the fourth frame hole 81d.

One end of the fifth cable Fe may be connected to a fifth connector of the LED driver P2, and the other end of the fifth cable Fe may be connected to the fifth connector 54e through the fifth frame hole 81e.

One end of the sixth cable Ff may be connected to a sixth connector of the LED driver P2, and the other end of the sixth cable Ff may be connected to the sixth connector 54f through the sixth frame hole 81f.

One end of the seventh cable Fg may be connected to a seventh connector of the LED driver P2, and the other end of the seventh cable Fg may be connected to the seventh connector 54g through the seventh frame hole 81g.

One end of the eighth cable Fh may be connected to an eighth connector of the LED driver P2, and the other end of the eighth cable Fh may be connected to the eighth connector 54h through the eighth frame hole 81h.

The back cover 90 may be located behind the frame 80 and may be coupled to the frame 80. The board P may be located between the frame 80 and the back cover 90 and may be covered by the back cover 90.

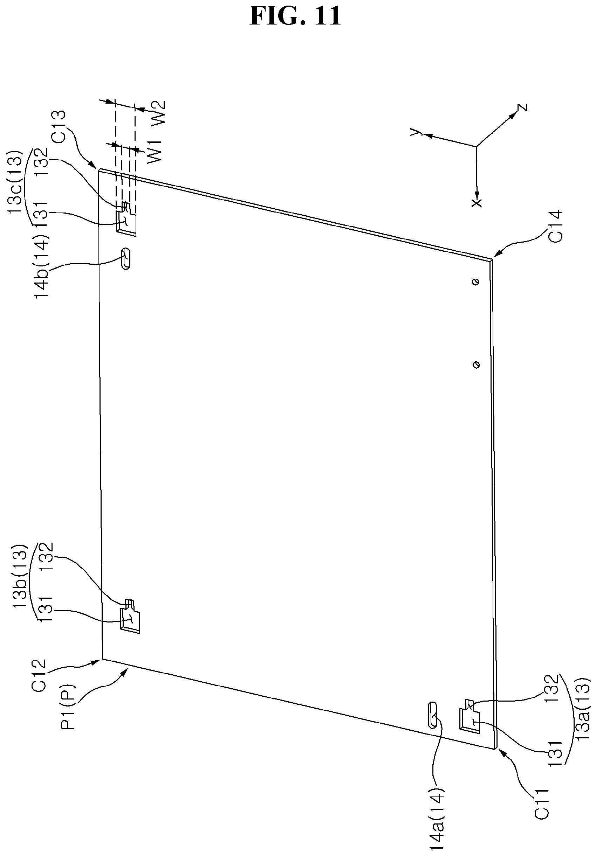

Referring to FIGs. 11 to 13, the board P may be the power supply board P1, and the power supply board P1 may be referred to as a first board P1 or a first substrate P1. For example, the first substrate P1 may be a rectangular board and may have four corners C11, C12, C13, and C14. The first substrate P1 may include a hole 13 and a slot 14 formed therein.

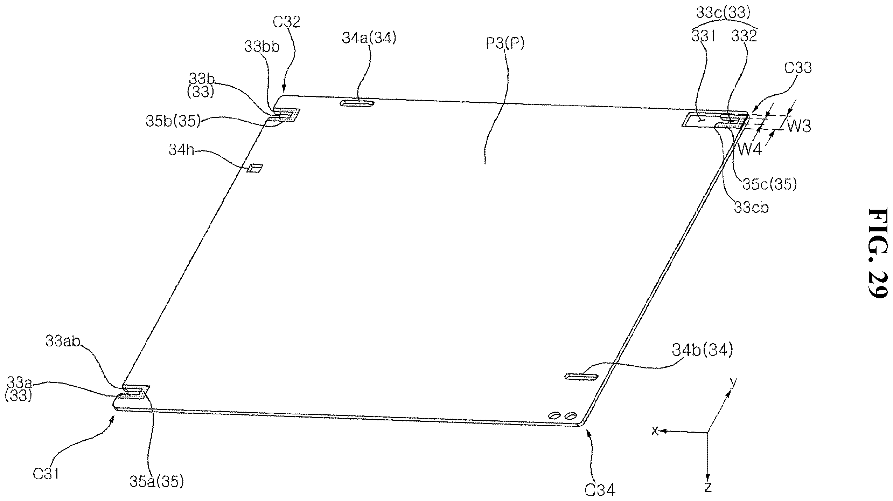

The hole 13 may be formed through the first substrate P1 and may be adjacent to a corner of the first substrate P1. Each of holes 13a, 13b, and 13c may be adjacent to a respective one of the corners C11, C12, and C13 of the first substrate P1. The first corner C11 may be formed at a point at which the lower side and left side of the first substrate P1 meet each other, and the first hole 13a may be adjacent to the first corner C11. The second corner C12 may be formed at a point at which the left side and upper side of the first substrate P1 meet each other, and the second hole 13b may be adjacent to the second corner C12. The third corner C13 may be formed at a point at which the upper side and right side of the first substrate P1 meet each other, and the third hole 13c may be adjacent to the third corner C13. The fourth corner C14 may be formed at a point at which the right side and lower side of the first substrate P1 meet each other. The holes 13a, 13b, and 13c may have the same shape. Alternatively, at least one of the first hole 13a or the second hole 13b may be formed in the shape of a notch-type hole in the left side of the first substrate P1, like first and second holes 33a and 33b to be described later with reference to FIG. 29. Each of the holes 13a, 13b, and 13c may have a " 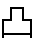 " shape and may include a first portion 131 and a second portion 132. The first portion 131 may be a rectangular hole having a relatively large width W2. The second portion 132 may be connected to the first portion 131 and may be a rectangular hole having a relatively small width W1.

The slot 14 may be formed through the first substrate P1 and may be spaced apart from the hole 13. The slot 14 may extend long in a direction in which the first portion 131 and second portion 132 of the hole 13 are connected to each other (i.e., the longitudinal direction of the hole 13). For example, the longitudinal directions of the hole 13 and the slot 14 may be defined as the leftward-rightward direction. The number of slots 14a and 14b may be equal to or less than the number of holes 13a, 13b, and 13c. The first slot 14a may be adjacent to the first hole 13a and may be formed to be elongated in the leftward-rightward direction. The second slot 14b may be adjacent to the third hole 13c and may be formed to be elongated in the leftward-rightward direction.

A clip 15 may include a body 151, arms 152 and 153, and legs 154 and 155. The clip 15 may be electrically conductive. The clip 15 may include metal. The clip 15 may be elastic. The body 151 may have a flat rectangular plate shape. A groove 151g may be formed in a first side 151a of the body 151 so as to extend in the inward direction of the body 151. The first arm 152 and the second arm 153 may protrude from the first side 151a, and the groove 151g may be formed between the first arm 152 and the second arm 153. The first arm 152 may be bent to be inclined forwardly from the first side 151a. An end 152a of the first arm 152 connected to the first side 151a may form a step elevated from the rear surface of the body 151. The second arm 153 may be bent to be inclined forwardly from the first side 151a. An end 153a of the second arm 153 connected to the first side 151a may form a step elevated from the rear surface of the body 151. The first leg 154 and the second leg 155 may be bent forwardly from a second side 151b and may be spaced apart from each other along the second side 151b.

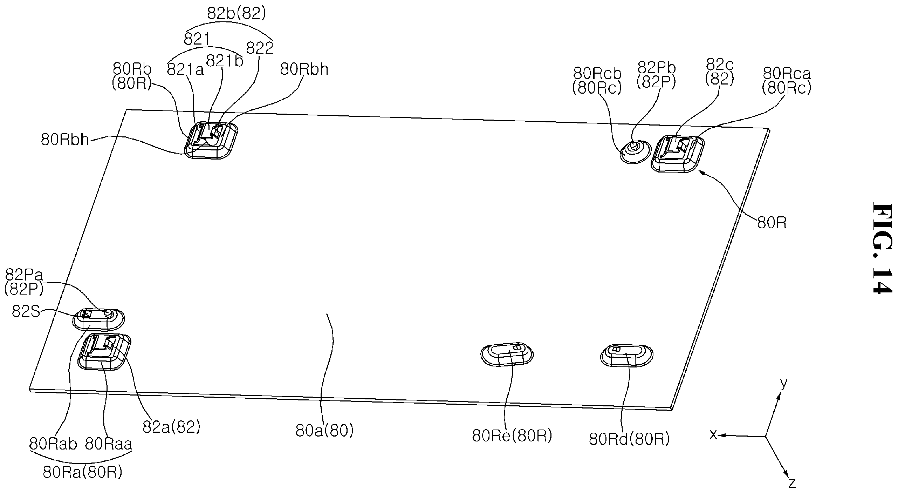

In addition, the clip 15 may include chamfered portions 152b and 153b formed on the inner side surfaces of the arms 152 and 153 that are adjacent to the distal ends of the arms 152 and 153. A gap Gb between the chamfered portions 152b and 153b may gradually increase in a direction away from the first side 151a. Accordingly, a second part 822 (refer to FIGs. 14 to 17) of a contact portion 82, which will be described later, may easily enter a region between the arms 152 and 153.

Each of the clips 15a, 15b, and 15c may be located next to a respective one of the holes 13a, 13b, and 13c and may be coupled to the first substrate P1. For example, the first substrate P1 may be a single-sided PCB. The single-sided PCB may be referred to as a one-layer PCB or a single-layer PCB. A circuit surface of the first substrate P1 on which a circuit pattern is formed may be the front surface of the first substrate P1.

The first clip 15a may be located next to the first hole 13a, and the body 151 of the first clip 15a may be located on the rear surface of the first substrate P1. The groove 151g in the body 151 may be aligned with the second portion 132 of the first hole 13a, and the width of the groove 151g may be equal to or slightly different from the width W1 of the second portion 132. The arms 152 and 153 of the first clip 15a may be located in the first portion 131 of the first hole 13a. The legs 154 and 155 of the first clip 15a may penetrate the first substrate P1, and the distal ends of the legs 154 and 155 may be soldered to the front surface of the first substrate P1. Accordingly, the first clip 15a may be electrically connected to the front surface of the first substrate P1, i.e., the circuit surface of the first substrate P1.

The second clip 15b may be located next to the second hole 13b, and the body 151 of the second clip 15b may be located on the rear surface of the first substrate P1. The groove 151g in the body 151 may be aligned with the second portion 132 of the second hole 13b, and the width of the groove 151g may be equal to or slightly different from the width W1 of the second portion 132. The arms 152 and 153 of the second clip 15b may be located in the first portion 131 of the second hole 13b. The legs 154 and 155 of the second clip 15b may penetrate the first substrate P1, and the distal ends of the legs 154 and 155 may be soldered to the front surface of the first substrate P1. Accordingly, the second clip 15b may be electrically connected to the front surface of the first substrate P1, i.e., the circuit surface of the first substrate P1.

The third clip 15c may be located next to the third hole 13c, and the body 151 of the third clip 15c may be located on the rear surface of the first substrate P1. The groove 151g in the body 151 may be aligned with the second portion 132 of the third hole 13c, and the width of the groove 151g may be equal to or slightly different from the width W1 of the second portion 132. The arms 152 and 153 of the third clip 15c may be located in the first portion 131 of the third hole 13c. The legs 154 and 155 of the third clip 15c may penetrate the first substrate P1, and the distal ends of the legs 154 and 155 may be soldered to the front surface of the first substrate P1. Accordingly, the third clip 15c may be electrically connected to the front surface of the first substrate P1, i.e., the circuit surface of the first substrate P1.

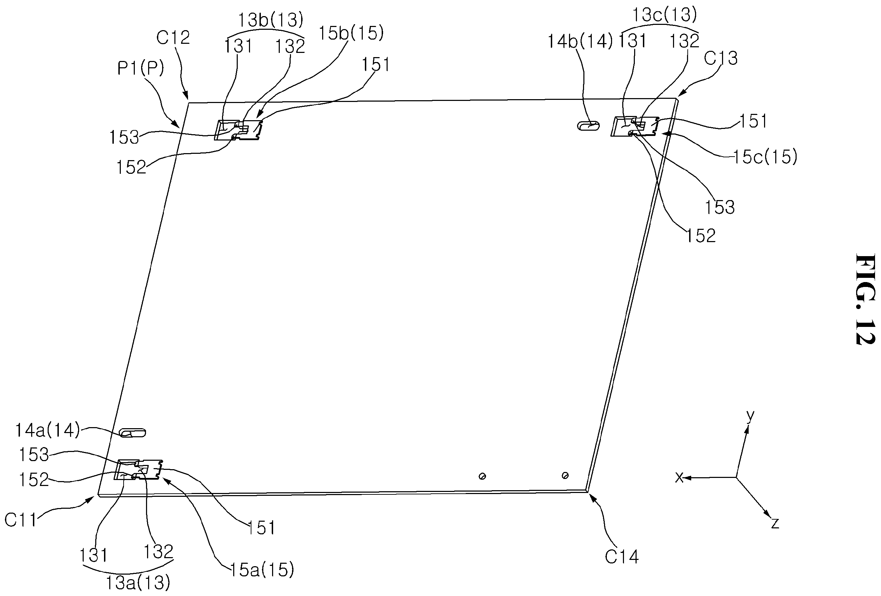

Referring to FIGs. 14 to 17, the first portion 80a of the frame 80 may face the first substrate P1 (refer to FIG. 12). Depressed portions 80R may be formed in the first portion 80a at positions corresponding to the hole 13 and the slot 14 in the first substrate P1. The depressed portions 80R may include the metal material of the frame 80 and may be electrically conductive. The depressed portions 80R may be formed by pressing the front surface of the first portion 80a in the backward direction and may form steps elevated from the rear surface of the first portion 80a. The heights of the depressed portions 80R from the rear surface of the first portion 80a may be equal to or slightly different from each other. The depressed portion 80R may be referred to as a pressed portion 80R.

The first depressed portion 80Ra may be depressed in the frame 80 toward the first hole 13a (refer to FIG. 12) in the first substrate P1. Two or more first depressed portions 80Ra may be formed (refer to FIG. 15), or one first depressed portion 80Ra may be formed (refer to FIG. 16). A pair of first depressed portions 80Ra may include a first fixing depressed portion 80Raa and a first guide depressed portion 80Rab.

The second depressed portion 80Rb may be depressed in the frame 80 toward the second hole 13b (refer to FIG. 12) in the first substrate P1.

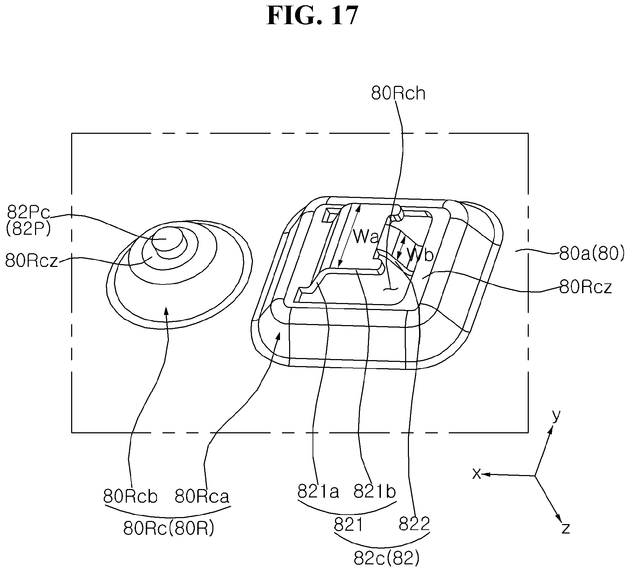

The third depressed portion 80Rc may be depressed in the frame 80 toward the third hole 13c (refer to FIG. 12) in the first substrate P1. Two or more third depressed portions 80Rc may be formed (refer to FIG. 17), or one third depressed portion 80Rc may be formed. A pair of third depressed portions 80Rc may include a third fixing depressed portion 80Rca and a third guide depressed portion 80Rcb.

The fourth depressed portion 80Rd may be depressed in the frame 80 toward a portion of the first substrate P1 adjacent to the fourth corner C14 (refer to FIG. 12). The fifth depressed portion 80Re may be depressed in the frame 80 and may be adjacent to the fourth depressed portion 80Rd.

A first contact portion 82a may protrude from the first depressed portion 80Ra toward the first hole 13a (refer to FIG. 12). The first contact portion 82a may be referred to as a first coupling portion 82a or a first protruding portion 82a. The first contact portion 82a may include a first part 821 and a second part 822. The first part 821 may include an inclined portion 821a, which is connected to a bottom part 80Raz of the first depressed portion 80Ra forming the rear end of the first depressed portion 80Ra, and a horizontal portion 821b, which is bent from the inclined portion 821a in a direction parallel to the first portion 80a. The second part 822 may extend from the horizontal portion 821b so as to be inclined and may be connected to the bottom part 80Raz. The width Wa of the first part 821 may be equal to or less than the width W2 (refer to FIG. 11) of the first portion 131 of the first hole 13a. The width Wb of the second part 822 may be equal to or less than the width W1 (refer to FIG. 11) of the second portion 132 of the first hole 13a. For example, the first contact portion 82a may be formed by pressing the front surface of the bottom part 80Raz in the backward direction, and a first hole 80Rah, which is larger than the first contact portion 82a, may be formed in the bottom part 80Raz according to the pressing process.

A second contact portion 82b may protrude from the second depressed portion 80Rb toward the second hole 13b (refer to FIG. 12). The second contact portion 82b may be referred to as a second coupling portion 82b or a second protruding portion 82b. The second contact portion 82b may include a first part 821 and a second part 822. The first part 821 may include an inclined portion 821a, which is connected to a bottom part 80Rbz of the second depressed portion 80Rb forming the rear end of the second depressed portion 80Rb, and a horizontal portion 821b, which is bent from the inclined portion 821a in a direction parallel to the first portion 80a. The second part 822 may extend from the horizontal portion 821b so as to be inclined and may be connected to the bottom part 80Rbz. The width Wa of the first part 821 may be equal to or less than the width W2 (refer to FIG. 11) of the first portion 131 of the second hole 13b. The width Wb of the second part 822 may be equal to or less than the width W1 (refer to FIG. 11) of the second portion 132 of the second hole 13b. For example, the second contact portion 82b may be formed by pressing the front surface of the bottom part 80Rbz in the backward direction, and a second hole 80Rbh, which is larger than the second contact portion 82b, may be formed in the bottom part 80Rbz according to the pressing process.

A third contact portion 82c may protrude from the third depressed portion 80Rc toward the third hole 13c (refer to FIG. 12). The third contact portion 82c may be referred to as a third coupling portion 82c or a third protruding portion 82c. The third contact portion 82c may include a first part 821 and a second part 822. The first part 821 may include an inclined portion 821a, which is connected to a bottom part 80Rcz of the third depressed portion 80Rc forming the rear end of the third depressed portion 80Rc, and a horizontal portion 821b, which is bent from the inclined portion 821a in a direction parallel to the first portion 80a. The second part 822 may extend from the horizontal portion 821b so as to be inclined and may be connected to the bottom part 80Rcz. The width Wa of the first part 821 may be equal to or less than the width W2 (refer to FIG. 11) of the first portion 131 of the third hole 13c. The width Wb of the second part 822 may be equal to or less than the width W1 (refer to FIG. 11) of the second portion 132 of the third hole 13c. For example, the third contact portion 82c may be formed by pressing the front surface of the bottom part 80Rcz in the backward direction, and a third hole 80Rch, which is larger than the third contact portion 82c, may be formed in the bottom part 80Rcz according to the pressing process.

The first to third contact portions 82a, 82b, and 82c may have the same shape. The first to third contact portions 82a, 82b, and 82c may be collectively referred to as a contact portion 82. The contact portion 82 may include the metal material of the frame 80 and the depressed portion 80R and may be electrically conductive. The contact portion 82 may be elastic.

A first pin 82Pa may protrude from the first depressed portion 80Ra toward the first slot 14a (refer to FIG. 12). The diameter or width of the first pin 82Pa may be less than the length of the first slot 14a, and the first pin 82Pa may be relatively movable along the first slot 14a. The first pin 82Pa may be referred to as a first protrusion 82Pa or a first boss 82Pa.

A second pin 82Pb may protrude from the third depressed portion 80Rc toward the second slot 14b (refer to FIG. 12). The diameter or width of the second pin 82Pb may be less than the length of the second slot 14b, and the second pin 82Pb may be relatively movable along the second slot 14b. The second pin 82Pb may be referred to as a second protrusion 82Pb or a second boss 82Pb.

The first and second pins 82Pa and 82Pb may have the same shape. The first and second pins 82Pa and 82Pb may be collectively referred to as a pin 82P. The pin 82P may have a hollow or solid cylindrical shape. One of the first and second pins 82Pa and 82Pb may be omitted. In this case, the slot in the first substrate P1 corresponding to the omitted pin may also be omitted. In addition to the first and second pins 82Pa and 82Pb, pins 82P may be additionally formed in the other depressed portions 80Rb, 80Rd, and 80Re. In this case, slots corresponding to the added pins may be additionally formed in the first substrate P1.

A protrusion 82S may protrude from the first depressed portion 80Ra in the same direction as the protruding direction of the first pin 82Pa and may be spaced apart from the first pin 82Pa in the longitudinal direction of the first slot 14a. A distance between the first pin 82Pa and the protrusion 82S may correspond to the length of the first slot 14a. A first surface 82S1 of the protrusion 82S facing the first pin 82Pa may be inclined at an obtuse angle with respect to the bottom part 80Raz of the first depressed portion 80Ra. A second surface 82S2 of the protrusion 82S, which is opposite the first surface 82S1, may intersect (be perpendicular to) the bottom part 80Raz. The protrusion 82S may have a pyramid shape with a portion cut out, and the second surface 82S2 may be formed on the cut-out portion. For example, the protrusion 82S may be formed by pressing the front surface of the bottom part 80Raz in the backward direction, and a hole 80Rh, which is larger than the protrusion 82S, may be formed in the bottom part 80Raz according to the pressing process. Protrusions 82S substituting for or provided in addition to the protrusion 82S formed in the first depressed portion 80Ra may be additionally formed in the other depressed portions 80Rb, 80Rc, 80Rd, and 80Re. In this case, slots corresponding to the substituting or added protrusions 82S may be additionally formed in the first substrate P1.

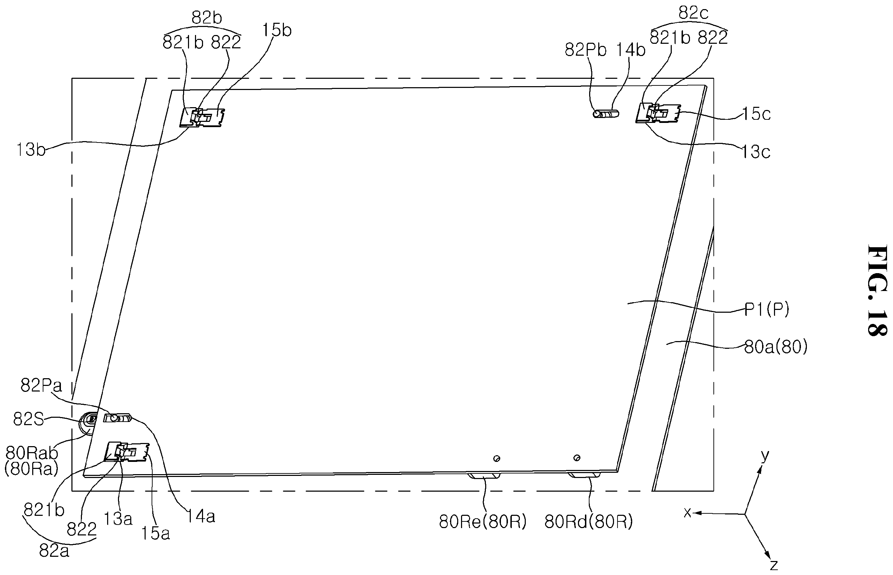

Referring to FIGs. 18 and 14, the first substrate P1 may be seated on the depressed portions 80R in the first portion 80a of the frame 80. The front surface of the first substrate P1 may be seated on the rear surfaces of the bottom parts of the depressed portions 80R. The first substrate P1 seated on the depressed portions 80R may be disposed parallel to the first portion 80a of the frame 80.

Each of the first to third contact portions 82a, 82b, and 82c may be inserted into the first portion 131 of a respective one of the first to third holes 13a, 13b, and 13c. Each of the first and second pins 82Pa and 82Pb may be inserted into a respective one of the first and second slots 14a and 14b.

A user may move the first substrate P1 so that the first to third clips 15a, 15b, and 15c approach the first to third contact portions 82a, 82b, and 82c. For example, the user may push the first substrate P1 seated on the depressed portions 80R to the left.

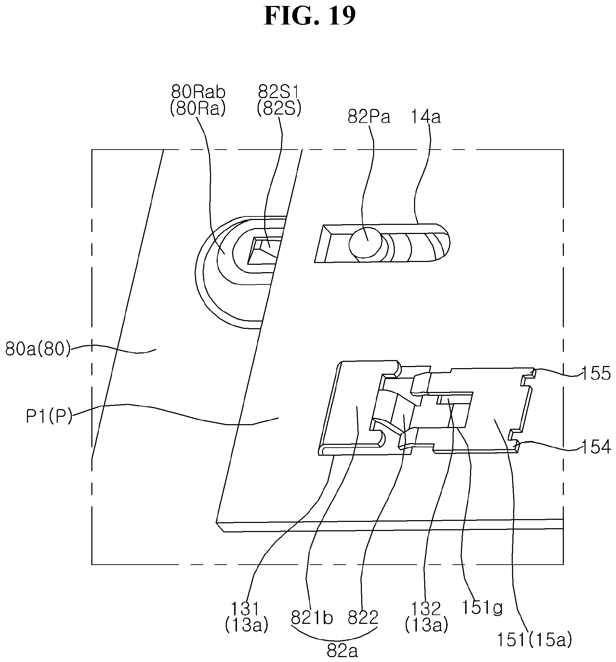

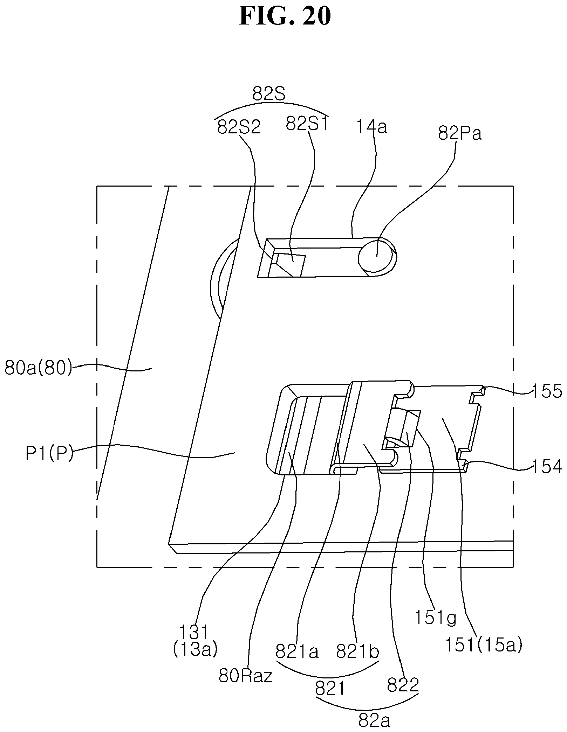

Referring to FIGs. 19 and 20, in response to the user's action of pushing the first substrate P1 to the left, the first clip 15a fixed to the first substrate P1 may approach the first contact portion 82a. In this case, the first pin 82Pa may move relatively in the first slot 14a and may guide movement of the first substrate P1.

Accordingly, the second part 822 of the first contact portion 82a may be inserted into the second portion 132 of the first hole 13a and the groove 151g in the first clip 15a, and the front surface of the horizontal portion 821b of the first part 821 of the first contact portion 82a may be located on the rear surface of the body 151 of the first clip 15a.

Further, the first substrate P1 may be slightly lifted while moving along the first surface 82S1 of the protrusion 82S, and may then be lowered back onto the first depressed portion 80Ra as the protrusion 82S is inserted into the first slot 14a. One end of the first slot 14a may be caught by the first pin 82Pa, and thus the first pin 82Pa may restrict movement of the first substrate P1 to the left. The other end of the first slot 14a may be caught by the second surface 82S2 of the protrusion 82S, and thus the protrusion 82S may restrict movement of the first substrate P1 to the right.

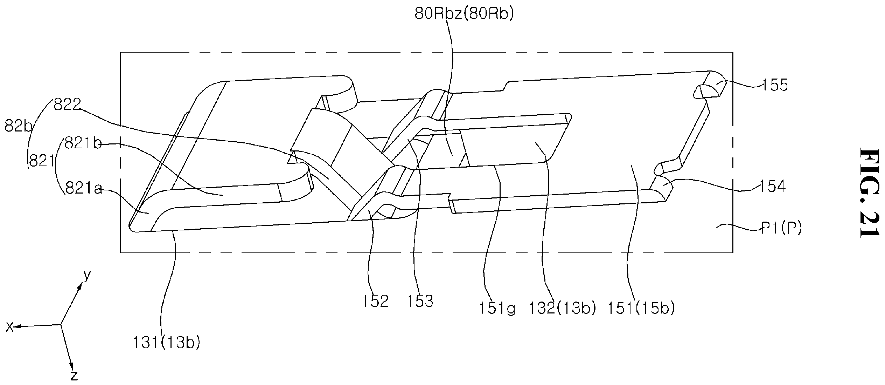

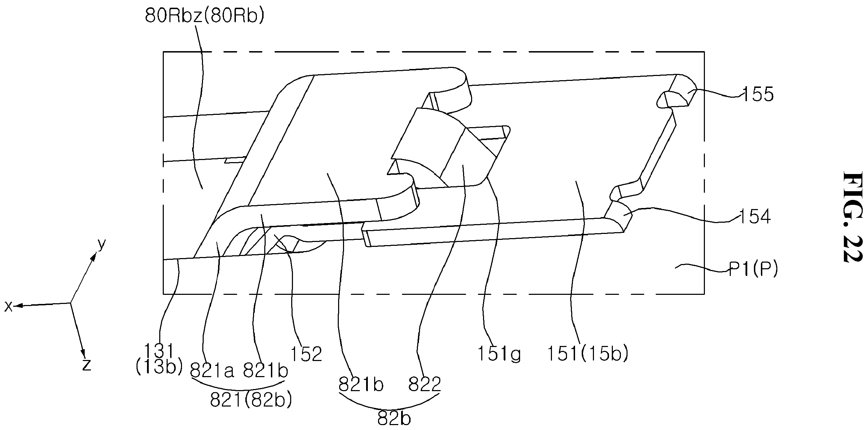

Referring to FIGs. 21 and 22, in response to the user's action of pushing the first substrate P1 to the left, the second clip 15b fixed to the first substrate P1 may approach the second contact portion 82b.

Accordingly, the second part 822 of the second contact portion 82b may be inserted into the second portion 132 of the second hole 13b and the groove 151g in the second clip 15b, and the front surface of the horizontal portion 821b of the first part 821 of the second contact portion 82b may be located on the rear surface of the body 151 of the second clip 15b.

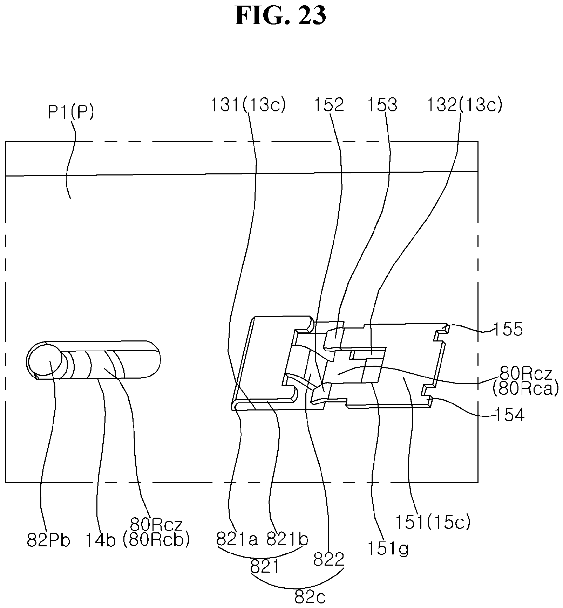

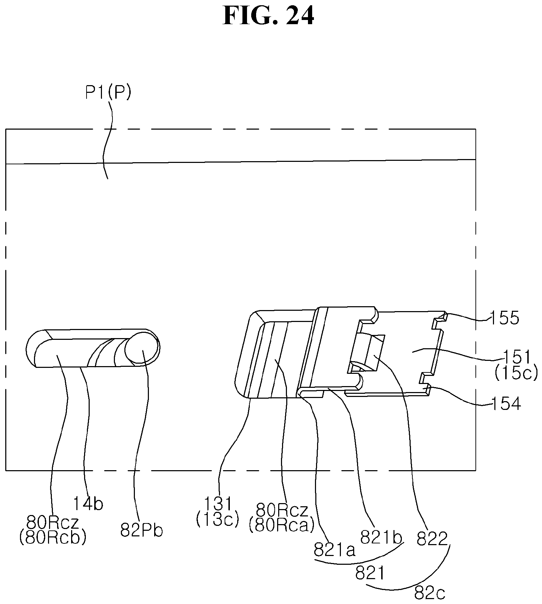

Referring to FIGs. 23 and 24, in response to the user's action of pushing the first substrate P1 to the left, the third clip 15c fixed to the first substrate P1 may approach the third contact portion 82c. In this case, the second pin 82Pb may move relatively in the second slot 14b and may guide movement of the first substrate P1.

Accordingly, the second part 822 of the third contact portion 82c may be inserted into the second portion 132 of the third hole 13c and the groove 151g in the third clip 15c, and the front surface of the horizontal portion 821b of the first part 821 of the third contact portion 82c may be located on the rear surface of the body 151 of the third clip 15c.

Further, one end of the second slot 14b may be caught by the second pin 82Pb, and thus the second pin 82Pb may restrict movement of the first substrate P1 to the left.

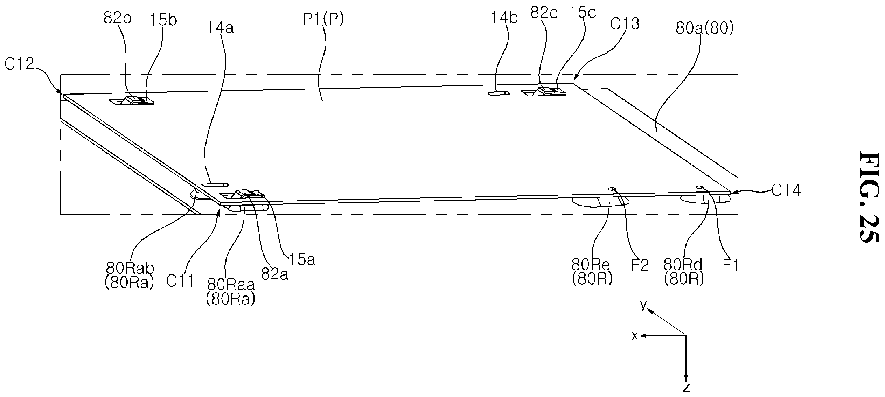

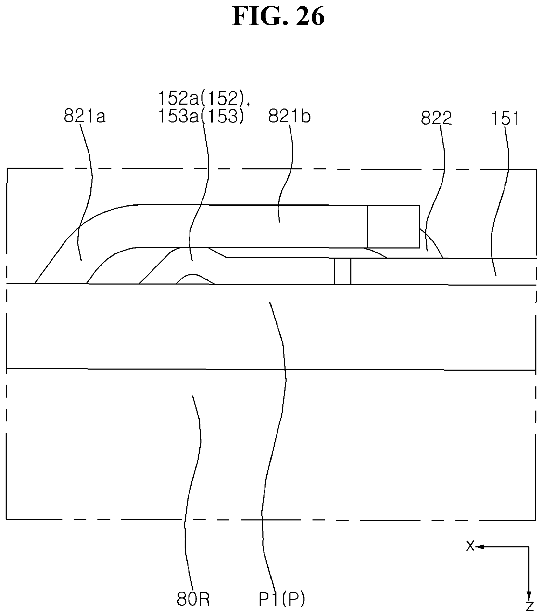

Referring to FIGs. 25 and 26, the ends 152a and 153a of the arms 152 and 153 of the clips 15a, 15b, and 15c may form steps elevated from the rear surfaces of the bodies 151. The horizontal portion 821b may be secured to the depressed portion 80R by the inclined portion 821a and the second part 822 and may press the ends 152a and 153a of the arms 152 and 153 in the forward direction. Accordingly, contact between the contact portion 82 and the clip 15 may be continuously and stably maintained, and the first substrate P1 may be electrically grounded to the frame 80 through the clip 15 and the contact portion 82.

Movement of the first substrate P1 in the horizontal direction (i.e., leftward-rightward direction) and the vertical direction (i.e., upward-downward direction) may be restricted by the pins 82Pa and 82Pb and the protrusion 82S inserted into the slots 14a and 14b and the contact portions 82a, 82b, and 82c inserted into the holes 13a, 13b, and 13c. Further, the horizontal portions 821b of the contact portions 82a, 82b, and 82c may press the clips 15a, 15b, and 15c fixed to the first substrate P1 in the forward direction, and movement of the first substrate P1 in the backward direction may be restricted by the contact portions 82a, 82b, and 82c.

Accordingly, the first substrate P1 may be detachably coupled to the first portion 80a of the frame 80. That is, the first substrate P1 may be coupled to the first portion 80a without fastening members.

Alternatively, portions of the first substrate P1 that are adjacent to the first to third corners C11, C12, and C13 may be coupled to the first to third depressed portions 80Ra, 80Rb, and 80Rc, and a portion of the first substrate P1 that is adjacent to the fourth corner C14 may be coupled to the fourth and fifth depressed portions 80Rd and 80Re by means of fastening members F1 and F2 such as screws.

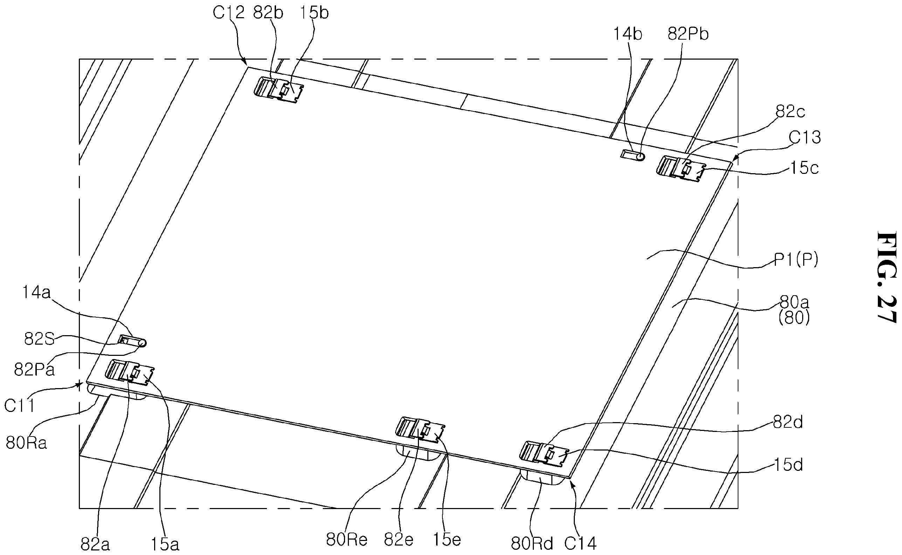

Referring to FIG. 27, the clips 15d and 15e may also be fixed to the portion of the first substrate P1 that is adjacent to the fourth corner C14. In this case, the contact portions 82d and 82e may be formed on the fourth and fifth depressed portions 80Rd and 80Re and may be coupled to the clips 15d and 15e. Accordingly, the first substrate P1 may be more stably coupled to the first portion 80a of the frame 80.

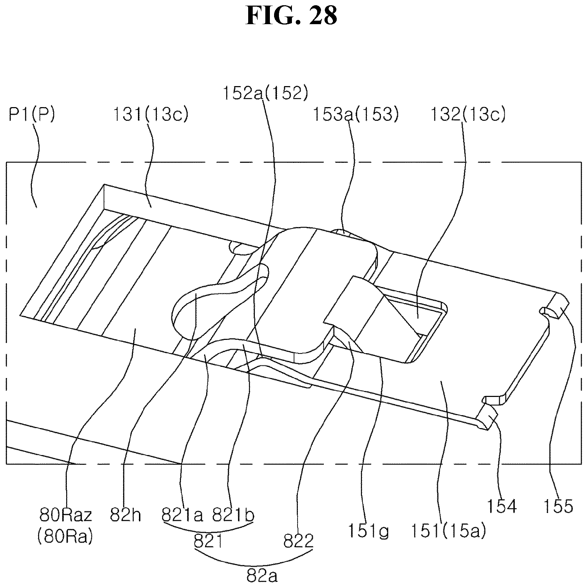

Referring to FIG. 28, a hole 82h may be formed at the bottom part 80Raz of the first depressed portion 80Ra and/or the inclined portion 821a of the first contact portion 82a. The hole 82h may be adjacent to a boundary between the bottom part 80Raz and the inclined portion 821a. The hole 82h may be located at the boundary between the bottom part 80Raz and the inclined portion 821a. The hole 82h may be a circular (oval) hole. Accordingly, the mold stability may be improved.

Similarly, the hole 82h may be formed at the bottom parts of other depressed portions 80Rb, 80Rc, 80Rd and 80Re and/or the inclined portions of other contact portions 82b, 82c, 82d and 82e.

Referring to FIG. 29, the board P may be the main board P3, and the main board P3 may be referred to as a second board P3 or a second substrate P3. For example, the second substrate P3 may be a rectangular board and may have four corners C31, C32, C33, and C34. The second substrate P3 may include a hole 33 and a slot 34 formed therein.

The hole 33 may be formed through the second substrate P3 and may be adjacent to a corner of the second substrate P3. Each of holes 33a, 33b, and 33c may be adjacent to a respective one of the corners C31, C32, and C33 of the second substrate P3. The first corner C31 may be formed at a point at which the lower side and left side of the second substrate P3 meet each other, and the first hole 33a may be adjacent to the first corner C31. The second corner C32 may be formed at a point at which the left side and upper side of the second substrate P3 meet each other, and the second hole 33b may be adjacent to the second corner C32. The third corner C33 may be formed at a point at which the upper side and right side of the second substrate P3 meet each other, and the third hole 33c may be adjacent to the third corner C33. The fourth corner C34 may be formed at a point at which the right side and lower side of the second substrate P3 meet each other. The first and second holes 33a and 33b may be formed in the left side of the second substrate P3 so as to extend in the inward direction of the second substrate P3 and may be notch-type holes. Alternatively, at least one of the first hole 33a or the second hole 33b may have a " 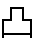 " shape. The third hole 33c may have a " 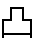 " shape and may include a first portion 331 and a second portion 332. The first portion 331 may be a rectangular hole having a relatively large width W3. The second portion 332 may be a rectangular hole having a relatively small width W4.

In addition, the hole 33 may include a chamfered portion formed on a distal end thereof. A chamfered portion 33ab may be formed on a portion adjacent to the left end of the first hole 33a, and the width of the chamfered portion 33ab may gradually increase in a direction approaching the left side of the second substrate P3. Accordingly, a second part 842 of a first contact portion 84a, which will be described later, may easily enter the first hole 33a. A chamfered portion 33bb may be formed on a portion adjacent to the left end of the second hole 33b, and the width of the chamfered portion 33bb may gradually increase in a direction approaching the left side of the second substrate P3. Accordingly, a second part 842 of a second contact portion 84b, which will be described later, may easily enter the second hole 33b. A chamfered portion 33cb may be formed on a part of the second portion 332 that is adjacent to the first portion 331 of the third hole 33c, and the width of the chamfered portion 33cb may gradually increase in a direction approaching the first portion 331. Accordingly, a second part 842 of a third contact portion 84c, which will be described later, may easily enter the second portion 332.

The slot 34 may be formed through the second substrate P3 and may be spaced apart from the hole 33. The slot 34 may extend long in the longitudinal direction of the hole 33. For example, the longitudinal directions of the hole 33 and the slot 34 may be defined as the leftward-rightward direction. The number of slots 34a and 34b may be equal to or less than the number of holes 33a, 33b, and 33c. The first slot 34a may be adjacent to the second corner C32 and may be formed to be elongated in the leftward-rightward direction. The second slot 34b may be adjacent to the fourth corner C34 and may be formed to be elongated in the leftward-rightward direction.

An insertion hole 34h may be formed through the second substrate P3 and may be spaced apart from the first slot 34a in the longitudinal direction of the first slot 34a. The insertion hole 34h may be located closer to the left side of the second substrate P3 than the first slot 34a. The insertion hole 34h may be spaced apart from the first slot 34a in a direction intersecting the longitudinal direction of the first slot 34a.

A contact region 35 may be formed around the hole 33 and may be a portion of the rear surface of the second substrate P3. The contact region 35 may be formed along the hole 33. The first contact region 35a may be formed along the first hole 33a around the first hole 33a. The second contact region 35b may be formed along the second hole 33b around the second hole 33b. The third contact region 35c may be formed along the second portion 332 of the third hole 33c around the second portion 332. The contact region 35 may be a portion of the circuit surface of the second substrate P3. For example, the second substrate P3 may be a double-sided PCB or a multilayer PCB. The circuit surface of the second substrate P3 on which a circuit pattern is formed may be the rear surface of the second substrate P3 or the rear and front surfaces of the second substrate P3. The contact region 35 may be a region in which a portion of the circuit surface of the second substrate P3 is open.

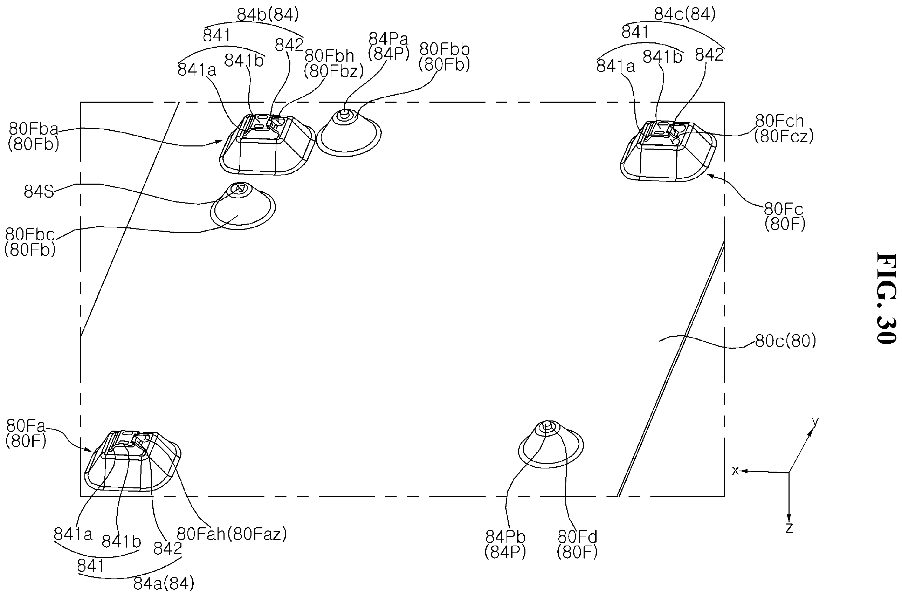

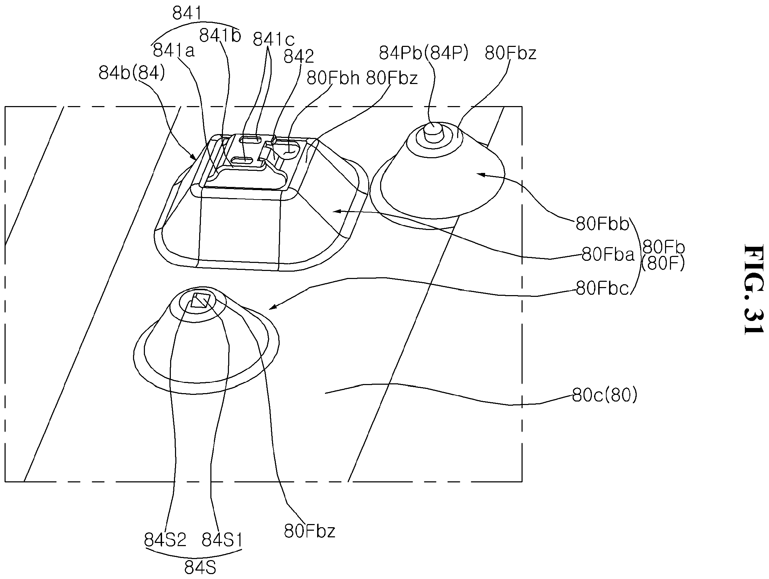

Referring to FIGs. 30 and 31, the second portion 80c of the frame 80 may face the second substrate P3 (refer to FIG. 29). Depressed portions 80F may be formed in the second portion 80c at positions corresponding to the hole 33 and the slot 34 in the second substrate P3. The depressed portions 80F may include the metal material of the frame 80 and may be electrically conductive. The depressed portions 80F may be formed by pressing the front surface of the second portion 80c in the backward direction and may form steps elevated from the rear surface of the second portion 80c. The heights of the depressed portions 80F from the rear surface of the second portion 80c may be equal to or slightly different from each other. The depressed portion 80F may be referred to as a pressed portion 80F.

The first depressed portion 80Fa may be depressed in the frame 80 toward the first hole 33a (refer to FIG. 29) in the second substrate P3.

The second depressed portion 80Fb may be depressed in the frame 80 toward the second hole 33b in the second substrate P3. Two or more second depressed portions 80Fb may be formed (refer to FIG. 30), or one second depressed portion 80Fb may be formed. A plurality of second depressed portions 80Fb may include a second fixing depressed portion 80Fba, a second guide depressed portion 80Fbb, and a second coupling depressed portion 80Fbc.

The third depressed portion 80Fc may be depressed in the frame 80 toward the third hole 33c (refer to FIG. 29) in the second substrate P3.

The fourth depressed portion 80Fd may be depressed in the frame 80 toward a portion of the second substrate P3 adjacent to the fourth corner C34 (refer to FIG. 29).

A first contact portion 84a may protrude from the first depressed portion 80Fa toward the first hole 33a (refer to FIG. 29). The first contact portion 84a may be referred to as a first coupling portion 84a or a first protruding portion 84a. The first contact portion 84a may include a first part 841 and a second part 842. The first part 841 may include an inclined portion 841a, which is connected to a bottom part 80Faz of the first depressed portion 80Fa forming the rear end of the first depressed portion 80Fa, and a horizontal portion 841b, which is bent from the inclined portion 841a in a direction parallel to the second portion 80c. The second part 842 may extend from the horizontal portion 841b so as to be inclined and may be connected to the bottom part 80Faz. The width of the first part 841 may be greater than the width of the first hole 33a, and the width of the second part 842 may be equal to or less than the width of the first hole 33a. For example, the first contact portion 84a may be formed by pressing the front surface of the bottom part 80Faz in the backward direction, and a first hole 80Fah, which is larger than the first contact portion 84a, may be formed in the bottom part 80Faz according to the pressing process.

A second contact portion 84b may protrude from the second depressed portion 80Fb toward the second hole 33b (refer to FIG. 29). The second contact portion 84b may be referred to as a second coupling portion 84b or a second protruding portion 84b. The second contact portion 84b may include a first part 841 and a second part 842. The first part 841 may include an inclined portion 841a, which is connected to a bottom part 80Fbz of the second depressed portion 80Fb forming the rear end of the second depressed portion 80Fb, and a horizontal portion 841b, which is bent from the inclined portion 841a in a direction parallel to the second portion 80c. The second part 842 may extend from the horizontal portion 841b so as to be inclined and may be connected to the bottom part 80Fbz. The width of the first part 841 may be greater than the width of the second hole 33b, and the width of the second part 842 may be equal to or less than the width of the second hole 33b. For example, the second contact portion 84b may be formed by pressing the front surface of the bottom part 80Fbz in the backward direction, and a second hole 80Fbh, which is larger than the second contact portion 84b, may be formed in the bottom part 80Fbz according to the pressing process.

A third contact portion 84c may protrude from the third depressed portion 80Fc toward the third hole 33c (refer to FIG. 29). The third contact portion 84c may be referred to as a third coupling portion 84c or a third protruding portion 84c. The third contact portion 84c may include a first part 841 and a second part 842. The first part 841 may include an inclined portion 841a, which is connected to a bottom part 80Fcz of the third depressed portion 80Fc forming the rear end of the third depressed portion 80Fc, and a horizontal portion 841b, which is bent from the inclined portion 841a in a direction parallel to the second portion 80c. The second part 842 may extend from the horizontal portion 841b so as to be inclined and may be connected to the bottom part 80Fcz. The width of the first part 841 may be equal to or less than the width W3 of the first portion 331 of the third hole 33c. The width of the second part 842 may be equal to or less than the width W4 of the second portion 332 of the third hole 33c. For example, the third contact portion 84c may be formed by pressing the front surface of the bottom part 80Fcz in the backward direction, and a third hole 80Fch, which is larger than the third contact portion 84c, may be formed in the bottom part 80Fcz according to the pressing process.

The first to third contact portions 84a, 84b, and 84c may have the same shape. The first to third contact portions 84a, 84b, and 84c may be collectively referred to as a contact portion 84. The contact portion 84 may include the metal material of the frame 80 and the depressed portion 80F and may be electrically conductive. The contact portion 84 may be elastic.

A first pin 84Pa may protrude from the second depressed portion 80Fb toward the first slot 34a (refer to FIG. 29). The diameter or width of the first pin 84Pa may be less than the length of the first slot 34a, and the first pin 84Pa may be relatively movable along the first slot 34a. The first pin 84Pa may be referred to as a first protrusion 84Pa or a first boss 84Pa.

A second pin 84Pb may protrude from the fourth depressed portion 80Fd toward the second slot 34b (refer to FIG. 29). The diameter or width of the second pin 84Pb may be less than the length of the second slot 34b, and the second pin 84Pb may be relatively movable along the second slot 34b. The second pin 84Pb may be referred to as a second protrusion 84Pb or a second boss 84Pb.

The first and second pins 84Pa and 84Pb may have the same shape. The first and second pins 84Pa and 84Pb may be collectively referred to as a pin 84P. The pin 84P may have a hollow or solid cylindrical shape. One of the first and second pins 84Pa and 84Pb may be omitted. In this case, the slot in the second substrate P3 corresponding to the omitted pin may also be omitted. In addition to the first and second pins 84Pa and 84Pb, pins 84P may be additionally formed in the other depressed portions 80Fa and 80Fc. In this case, slots corresponding to the added pins may be additionally formed in the second substrate P3.

A protrusion 84S may protrude from the second depressed portion 80Fb in the same direction as the protruding direction of the first pin 84Pa and may be spaced apart from the first pin 84Pa in the longitudinal direction of the first slot 34a. The protrusion 84S may face the insertion hole 34h (refer to FIG. 29) in the second substrate P3. A first surface 84S1 of the protrusion 84S may be inclined at an obtuse angle with respect to the bottom part 80Fbz of the second depressed portion 80Fb in the longitudinal direction of the first slot 34a. A second surface 84S2 of the protrusion 84S, which is opposite the first surface 84S1, may intersect (be perpendicular to) the bottom part 80Fbz. The protrusion 84S may have a pyramid shape with a portion cut out, and the second surface 84S2 may be formed on the cut-out portion. For example, the protrusion 84S may be formed by pressing the front surface of the bottom part 80Fbz in the backward direction, and a hole 80Fh, which is larger than the protrusion 84S, may be formed in the bottom part 80Fbz according to the pressing process. Protrusions 84S substituting for or provided in addition to the protrusion 84S formed in the second depressed portion 80Fb may be additionally formed in the other depressed portions 80Fa, 80Fc, and 80Fd. In this case, insertion holes corresponding to the substituting or added protrusions 84S may be additionally formed in the second substrate P3.

The protrusion 84S may be inserted into the slot instead of the insertion hole 34h in the second substrate P3, like the protrusion 82S (refer to FIG. 20). Alternatively, the protrusion 82S (refer to FIG. 20) may be inserted into the insertion hole instead of the first slot 14a in the first substrate P1, like the protrusion 84S.

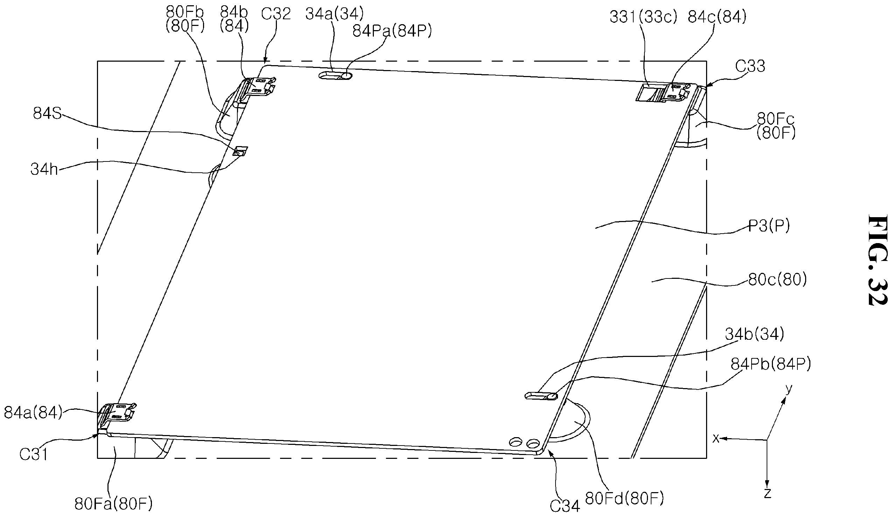

Referring to FIGs. 32 to 36, the second substrate P3 may be seated on the depressed portions 80F in the second portion 80c of the frame 80. The front surface of the second substrate P3 may be seated on the rear surfaces of the bottom parts of the depressed portions 80F. The second substrate P3 seated on the depressed portions 80F may be disposed parallel to the second portion 80c of the frame 80.

The first and second contact portions 84a and 84b may be adjacent to the left side of the second substrate P3, and the third contact portion 84c may be inserted into the first portion 331 of the third hole 33c.

The user may move the second substrate P3 so that the first to third contact regions 35a, 35b, and 35c (refer to FIG. 29) approach the first to third contact portions 84a, 84b, and 84c. For example, the user may push the second substrate P3 seated on the depressed portions 80F to the left.

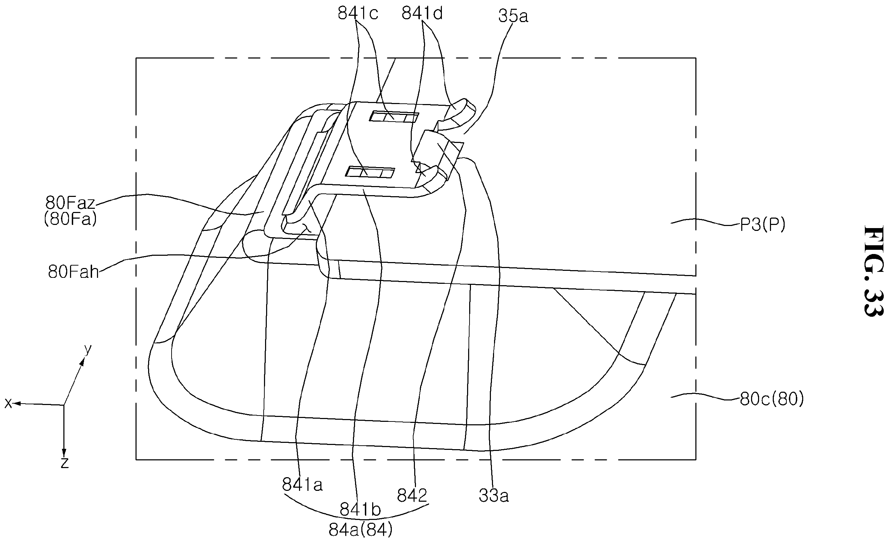

Referring to FIG. 33, in response to the user's action of pushing the second substrate P3 to the left, the second part 842 of the first contact portion 84a may be inserted into the first hole 33a, and the front surface of the horizontal portion 841b of the first part 841 of the first contact portion 84a may be located on the first contact region 35a. A bent portion 841d may be bent backward from the distal end of the horizontal portion 841b, and may facilitate movement of the first contact portion 84a relative to the second substrate P3. A pressed portion 841c may be formed by pressing the rear surface of the horizontal portion 841b in the forward direction and may protrude from the front surface of the horizontal portion 841b. The pressed portion 841c may come into contact with the first contact region 35a. Accordingly, contact between the first contact portion 84a and the first contact region 35a may be stably maintained. That is, the second substrate P3 may be electrically grounded to the frame 80 through the first contact region 35a and the first contact portion 84a.

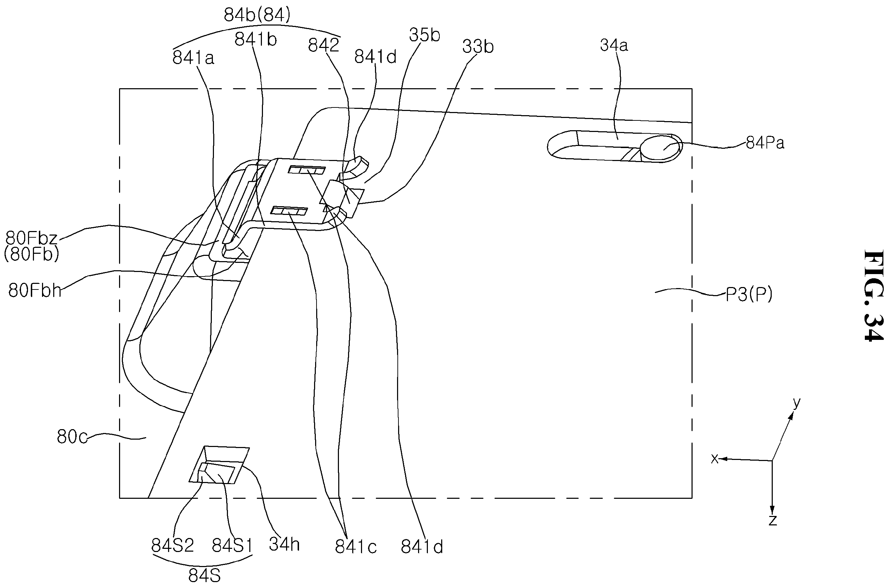

Referring to FIG. 34, in response to the user's action of pushing the second substrate P3 to the left, the second part 842 of the second contact portion 84b may be inserted into the second hole 33b, and the front surface of the horizontal portion 841b of the first part 841 of the second contact portion 84b may be located on the second contact region 35b. A bent portion 841d may be bent backward from the distal end of the horizontal portion 841b, and may facilitate movement of the second contact portion 84b relative to the second substrate P3. A pressed portion 841c may be formed by pressing the rear surface of the horizontal portion 841b in the forward direction and may protrude from the front surface of the horizontal portion 841b. The pressed portion 841c may come into contact with the second contact region 35b. Accordingly, contact between the second contact portion 84b and the second contact region 35b may be stably maintained. That is, the second substrate P3 may be electrically grounded to the frame 80 through the second contact region 35b and the second contact portion 84b.

Further, the first pin 84Pa may move relatively in the first slot 34a and may guide movement of the second substrate P3. The second substrate P3 may be slightly lifted while moving along the first surface 84S1 of the protrusion 84S, and may then be lowered back onto the second depressed portion 80Fb as the protrusion 84S is inserted into the insertion hole 34h. One end of the first slot 34a may be caught by the first pin 84Pa, and thus the first pin 84Pa may restrict movement of the second substrate P3 to the left. The insertion hole 34h may be caught by the second surface 84S2 of the protrusion 84S, and thus the protrusion 84S may restrict movement of the second substrate P3 to the right.

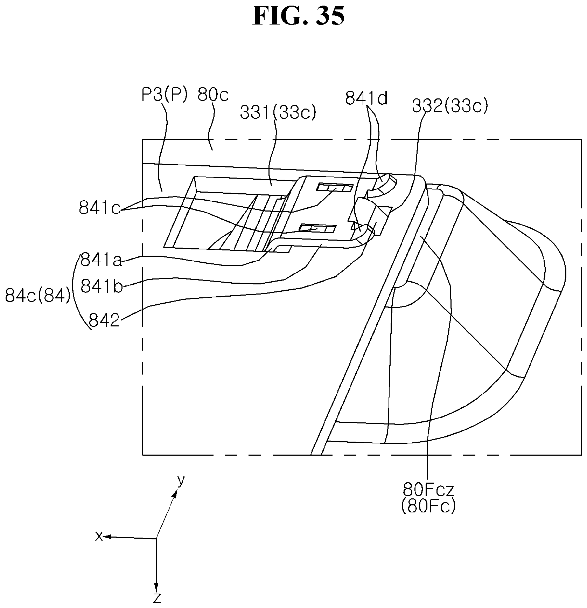

Referring to FIG. 35, in response to the user's action of pushing the second substrate P3 to the left, the second part 842 of the third contact portion 84c may be inserted into the second portion 332 of the third hole 33c, and the front surface of the horizontal portion 841b of the first part 841 of the third contact portion 84c may be located on the third contact region 35c. A bent portion 841d may be bent backward from the distal end of the horizontal portion 841b, and may facilitate movement of the third contact portion 84c relative to the second substrate P3. A pressed portion 841c may be formed by pressing the rear surface of the horizontal portion 841b in the forward direction and may protrude from the front surface of the horizontal portion 841b. The pressed portion 841c may come into contact with the third contact region 35c. Accordingly, contact between the third contact portion 84c and the third contact region 35c may be stably maintained. That is, the second substrate P3 may be electrically grounded to the frame 80 through the third contact region 35c and the third contact portion 84c.

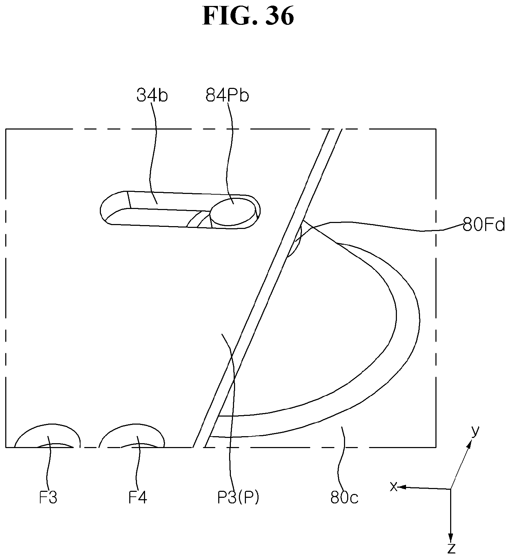

Referring to FIG. 36, in response to the user's action of pushing the second substrate P3 to the left, the second pin 84Pb may move relatively in the second slot 34b and may guide movement of the second substrate P3.

Movement of the second substrate P3 in the horizontal direction (i.e., leftward-rightward direction) and the vertical direction (i.e., upward-downward direction) may be restricted by the pins 84Pa and 84Pb inserted into the slots 34a and 34b, the protrusion 84S inserted into the insertion hole 34h, and the contact portions 84a, 84b, and 84c inserted into the holes 33a, 33b, and 33c. Further, the pressed portions 841c of the contact portions 84a, 84b, and 84c may press the contact regions 35a, 35b, and 35c of the second substrate P3 in the forward direction, and movement of the second substrate P3 in the backward direction may be restricted by the contact portions 84a, 84b, and 84c.

Accordingly, the second substrate P3 may be detachably coupled to the second portion 80c of the frame 80. That is, the second substrate P3 may be coupled to the second portion 80c without fastening members.

Alternatively, portions of the second substrate P3 that are adjacent to the first to third corners C31, C32, and C33 may be coupled to the first to third depressed portions 80Fa, 80Fb, and 80Fc, and a portion of the second substrate P3 that is adjacent to the fourth corner C34 may be coupled to the fourth depressed portion 80Fd by means of fastening members F3 and F4 such as screws.

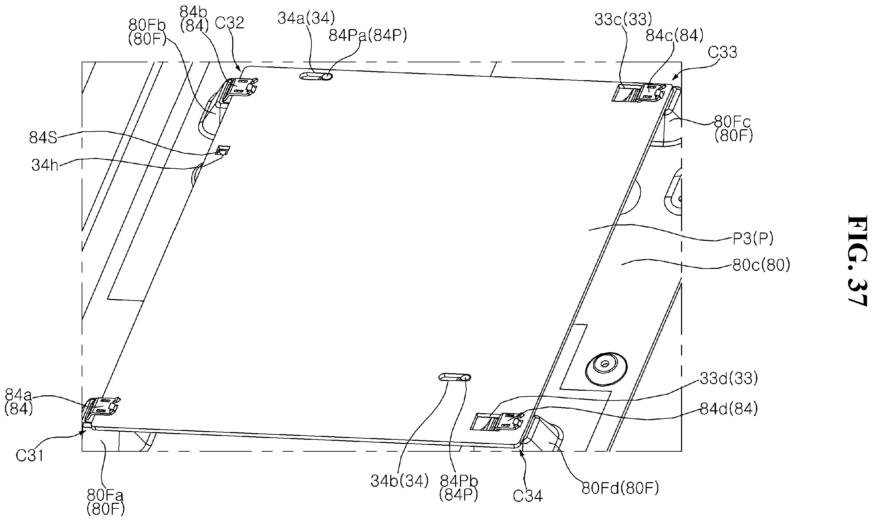

Referring to FIG. 37, the fourth contact portion 84d may be formed on the fourth depressed portion 80Fd and may be coupled to the hole 33d in the second substrate P3 adjacent to the fourth corner C34. Accordingly, the second substrate P3 may be more stably coupled to the second portion 80c of the frame 80.

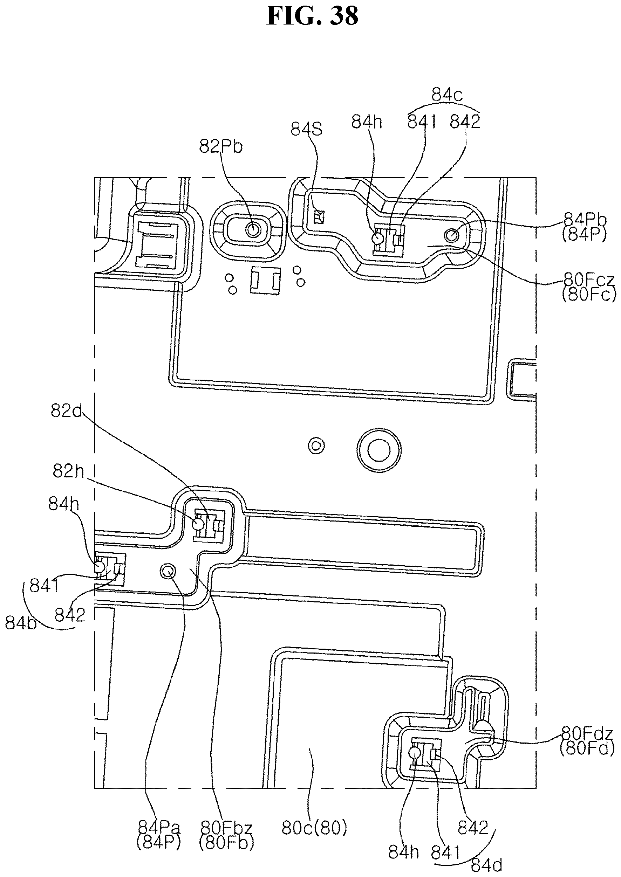

Referring to FIG. 38, a hole 84h may be formed at the bottom part 80Fbz of the second depressed portion 80Fb and/or the inclined portion of the second contact portion 84b. The hole 84h may be adjacent to a boundary between the bottom part 80Fbz and the inclined portion. The hole 84h may be located at the boundary between the bottom part 80Fbz and the inclined portion. The hole 84h may be a circular (oval) hole. Accordingly, the mold stability may be improved.

Similarly, the hole 84h may be formed at the bottom parts of other depressed portions 80Fc and 80Fd and/or the inclined portions of other contact portions 84c and 84d.

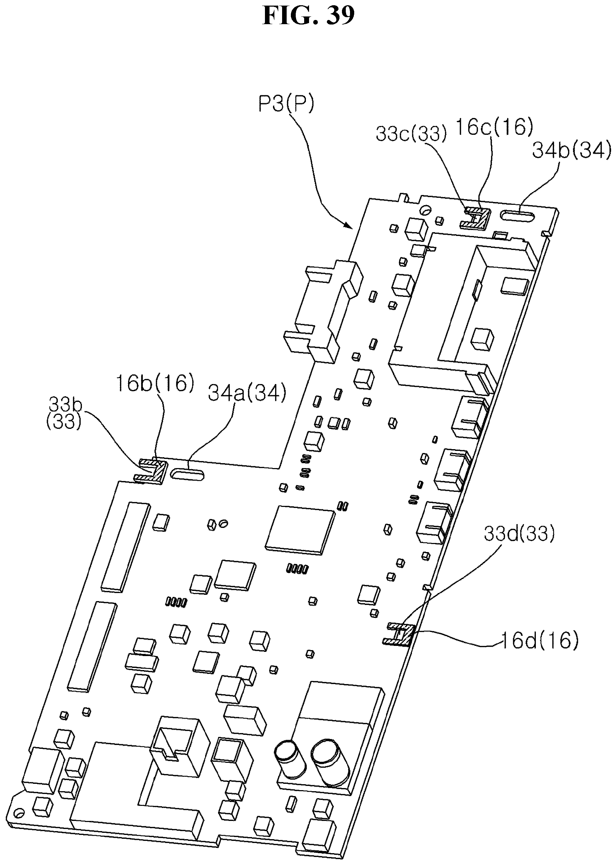

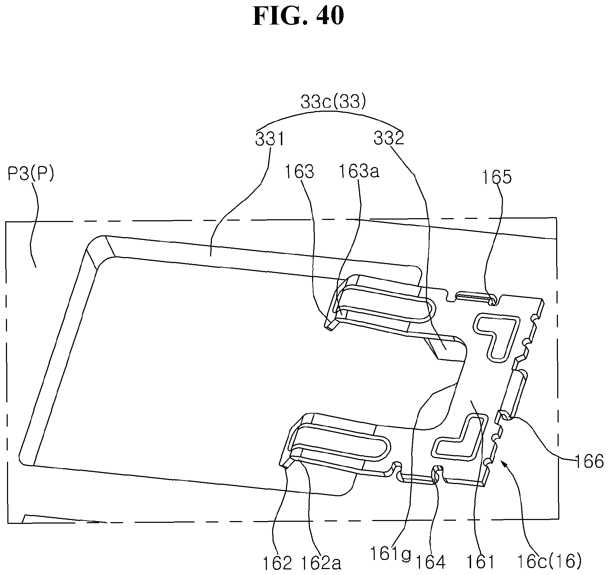

Referring to FIGs. 39 and 40, instead of the contact region 35 described above with reference to FIG. 29, etc., a clip 16 may be coupled to the second substrate P3 adjacent to the hole 33. The clip 16 may be electrically conductive. The clip 16 may be elastic. The clip 16 may include a metal material. The clip may include a body 161, arms 162 and 163, and legs 164, 165 and 166.

The body 161 may have a rectangular plate shape. A rigid portion or a pressed portion may be formed on a front or a rear of the body 161, and may be depressed from the body 161. The body 161 may be located on the second substrate P3 adjacent to the second portion 332 of the hole 33.

The arms 162 and 163 may protrude from one side of the body 161 and may be spaced apart from each other along the one side. A rigid portion or a pressed portion may be formed on a front or a rear of the arms 162 and 163, and may be depressed from the arms 162 and 163. A groove 161g may be formed between the arms 162 and 163. The arms 162 and 163 may extend in the longitudinal direction of the hole 33, and a portion of each arm may overlap the first portion 331 of the hole 33. A portion of the first arm 162 may be bent to form a first bent portion 162a, and a portion of the second arm 163 may also be bent to form a second bent portion 163a.

The legs 164, 165 and 166 may protrude from the other side of the body 161 toward the second substrate P3 and may be inserted into holes of the second substrate P3. The first leg 164, the second leg 165, and the third leg 166 may be arranged along an edge of the body 161. The legs 164, 165 and 166 may be electrically connected to the second substrate P3. For example, the legs 164, 165 and 166 may be soldered to the second substrate P3.

The second clip 16b may be adjacent to the second hole 33b, and the groove 161g of the second clip 16b may be aligned with the first hole 33a. The second hole 33b may have a shape corresponding to the second hole 33b of Fig. 29. The third clip 16c may be adjacent to the third hole 33c, and the groove 161g of the third clip 16c may be aligned with the second portion 332 of the third hole 33c. The third hole 33c may have a shape corresponding to the third hole 33c of Figs. 29 and 40. The fourth clip 16d may be adjacent to the fourth hole 33d, and the groove 161g of the fourth clip 16d may be aligned with the second portion 332 of the fourth hole 33d. The fourth hole 33d may have a shape corresponding to the third hole 33c of Fig. 29.

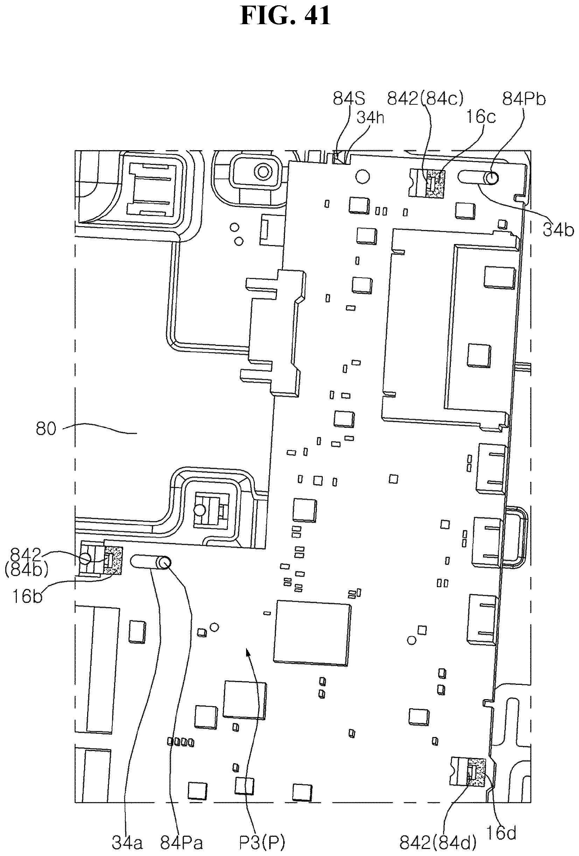

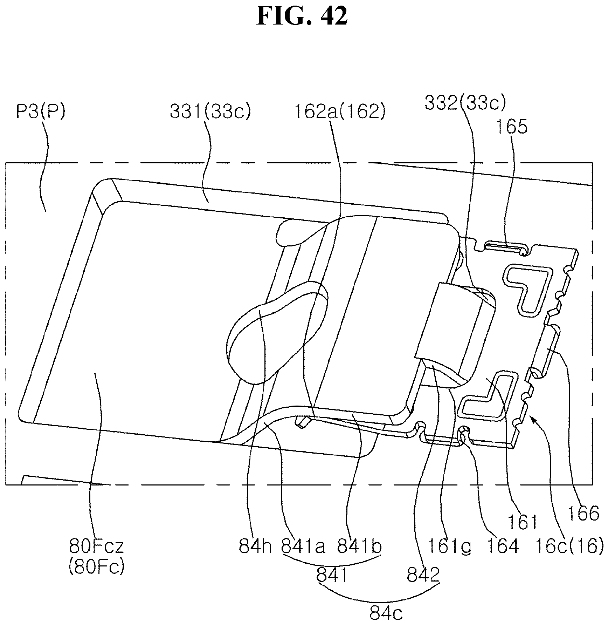

Referring to FIGs. 41 and 42 together with FIGs. 38 and 39, the second substrate P3 may be located on the depressed portions 80Fb, 80Fc and 80Fd of the frame 80. The contact portions 84b, 84c and 84d may be inserted into the holes 33b, 33c and 33d of the second substrate P3.

The user may move the second substrate P3 so that the clips 16b, 16c and 16d come closer to the contact portions 84b, 84c and 84d. For example, the user may push the second substrate P3 located on the depressed portions 80Fb, 80Fc and 80Fd to the left.

In response to a user's motion of sliding the second substrate P3 to the left, the second part 842 of the third contact portion 84c may be inserted into the groove 161g of the third clip 16c and the second part 332 of the third hole 33c, and the horizontal portion 841b of the third contact portion 84c may cover the arms 162 and 163. The horizontal portion 841b may contact the bent portions 162a and 163a of the arms 162 and 163 to press the arms 162 and 163 forward.

Accordingly, the second substrate P3 may be coupled to the third contact portion 84c via the third clip 16c. Similarly, the second substrate P3 may be coupled to the second contact portion 84b and the fourth contact portion 84d via the second clip 16b and the fourth clip 16d. The contact portions 84b, 84c and 84d may limit the forward and backward movement of the second substrate P3. In addition, the second substrate P3 may be electrically grounded to the frame 80 via the clips 16b, 16c and 16d, and EMI (Electro Magnetic Interference) noise or damage to the components on the second substrate P3 may be reduced.

The second substrate P3 may be restricted from moving in the horizontal and vertical directions by pins 84Pa and 84Pb and protrusions (84S) inserted into the slots 34a and 34b.

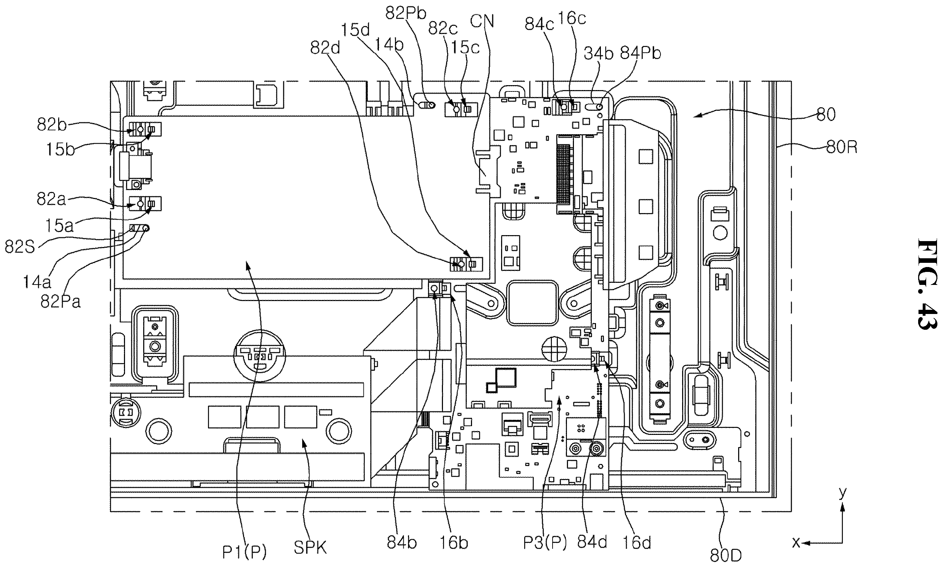

Referring to FIG. 43, the second substrate P3 may be coupled to the rear of the frame 80 via clips 16b, 16c and 16d, and the first substrate P1 may be coupled to the rear of the frame 80 via clips 15a, 15b, 15c and 15d. The second substrate P3 may be connected to the first substrate P1 via a connector CN. Alternatively, the second substrate P3 and the first substrate P1 may be formed as one substrate (i.e., as one body). The second substrate P3 may be a main board (P3), and the first substrate (P1) may be a power supply board (P1).

For example, a user may mount the first substrate P1 on the frame 80 by pushing it to the left (i.e., sliding it). Thereafter, the user may mount the second substrate P3 on the frame 80 by pushing it to the left (i.e., sliding it), and at this time, the connector (CN) of the second substrate P3 may be coupled to the first substrate P1. Alternatively, the second substrate P3 and the first substrate P1 may be formed as a single substrate, and the user may mount the integrated first and second substrates P1 and P3 on the frame 80 by pushing them to the left (i.e., sliding them).

Referring to FIGs. 1 to 43, a display device may include a display panel, a frame located behind the display panel, and a substrate located behind the frame and having a hole. The frame may include a depressed portion protruding from the frame toward the substrate and on which the substrate is located and a contact portion protruding from the depressed portion and inserted into the hole. A part of the contact portion may be located on the rear surface of the substrate.

The part of the contact portion may be in contact with the rear surface of the substrate. The part of the contact portion may press the rear surface of the substrate in a forward direction. The rear surface of the substrate may press the part of the contact portion in a backward direction.

The contact portion of the frame may be electrically connected to the substrate.

The display device may further include a clip located on the rear surface of the substrate around the hole. The clip may include a body located between the part of the contact portion and the rear surface of the substrate and a leg bent from one side of the body in the forward direction, inserted into the substrate, and electrically connected to the substrate.

The clip may further include an arm bent from the other side of the body so as to be inclined in the forward direction and including an end forming a step elevated from the body, and the part of the contact portion may be located on the end of the arm.

The arm may include a pair of arms spaced apart from each other along the other side of the body, and the contact portion may include a first part forming the part of the contact portion and a second part connecting the first part to the depressed portion and inserted into a region between the pair of arms. A gap between portions of the pair of arms adjacent to distal ends of the pair of arms may gradually increase in a direction away from the other side of the body.

The substrate may include a contact region formed around the hole and electrically connected to the part of the contact portion.

The contact portion may further include a pressed portion protruding from the part of the contact portion toward the contact region.

The contact portion may include a first part forming the part of the contact portion and a second part connecting the first part to the depressed portion and inserted into the hole. The hole may be formed to be elongated in a direction from the second part toward the first part, and the width of the hole adj acent to a distal end of the hole may gradually increase in a direction approaching the first part.

The contact portion may include a first part including an inclined portion extending from the depressed portion so as to be inclined and a horizontal portion bent from the inclined portion in a direction parallel to the substrate and a second part extending from the horizontal portion toward the depressed portion so as to be inclined to be connected to the depressed portion. The second part may have a width less than the width of the first part.

The hole may include a first portion having a width corresponding to the width of the first part and into which the first part is inserted and a second portion having a width corresponding to the width of the second part and into which the second part to be inserted. The horizontal portion may press the rear surface of the substrate around the second portion in the forward direction.

The depressed portion may be formed by pressing the front surface of the frame in the backward direction, and the contact portion may be formed by pressing the front surface of the depressed portion in the backward direction.

The frame may include a hole formed at the depressed portion or the contact portion adj acent to a boundary between the depressed portion and the contact portion.

The hole may be formed to be elongated, and the substrate may include a slot formed to be elongated in the same direction as the hole and spaced apart from the hole. The frame may further include a pin protruding from the depressed portion and movably inserted into the slot.

The frame may further include a protrusion protruding from the depressed portion, inserted into the slot, and spaced apart from the pin, and the protrusion may include a first surface facing the pin and inclined with respect to the depressed portion and a second surface opposite the first surface and to which one end of the slot is hung.

The substrate may further include an insertion hole spaced apart from the slot in the longitudinal direction of the slot, and the frame may further include a protrusion protruding from the depressed portion and inserted into the insertion hole. The protrusion may include a first surface inclined with respect to the depressed portion and a second surface opposite the first surface and to which the insertion hole is hung. One end of the slot may be hung by the pin.

The depressed portion may include a plurality of depressed portions spaced apart from each other, and the contact portion may include a plurality of contact portions formed at the plurality of depressed portions and coupled to the substrate adjacent to corners of the substrate

The substrate may be coupled to the contact portion by sliding.

The substrate may include: a first substrate; and a second substrate adjacent to the first substrate.

A display device may include: a display panel; a frame positioned behind the display panel; and a substrate positioned behind the frame and having a hole, wherein the frame may include: a depressed portion protruding from the frame toward the substrate and on which the substrate is positioned; and a contact portion protruding from the depressed portion and inserted into the hole, wherein a portion of the contact portion may press a rear surface of the substrate forward.

A display device may include: a display panel; a frame positioned behind the display panel; and a substrate positioned behind the frame and having a hole, wherein the frame may include: a depressed portion protruding from the frame toward the substrate and on which the substrate is positioned; and a contact portion protruding from the depressed portion and inserted into the hole, wherein the substrate may be slidably coupled to the contact portion, and escaping of the substrate in a rearward direction may be prevented by the contact portion.

The effects of a display device according the present disclosure will be described as follows.

According to at least one of embodiments of the present disclosure, a coupling structure between a frame and a substrate may be provided.

According to at least one of embodiments of the present disclosure, a structure allowing the substrate to be stably coupled to the frame without a separate fastening member such as a screw may be provided.

According to at least one of embodiments of the present disclosure, a structure for ensuring contact point stability between the substrate and the frame may be provided.

According to at least one of embodiments of the present disclosure, various examples of a coupling structure between the substrate and the frame may be provided.

The additional scope of applicability of the present disclosure will be apparent from the above detailed description. However, those skilled in the art will appreciate that various modifications and alterations are possible, without departing from the idea and scope of the present disclosure, and therefore it should be understood that the detailed description and specific embodiments, such as the preferred embodiments of the present disclosure, are provided only for illustration.

Certain embodiments or other embodiments of the disclosure described above are not mutually exclusive or distinct from each other. Any or all elements of the embodiments of the disclosure described above may be combined with each other in configuration or function.

For example, a configuration "A" described in one embodiment of the disclosure and/or the drawings and a configuration "B" described in another embodiment of the disclosure and/or the drawings may be combined with each other. Namely, although the combination between the configurations is not directly described, the combination is possible except in the case where it is described that the combination is impossible.

The above detailed description is not intended to be construed to limit the disclosure in all aspects and to be considered by way of example. The scope of the disclosure should be determined by reasonable interpretation of the appended claims and all equivalent modifications made without departing from the disclosure should be included in the following claims.

## Claims

1. A display device (1) comprising:
a display panel (10);
a frame (80) located behind the display panel (10); and
a substrate (P) located behind the frame (80) and having a hole (13; 33),
wherein the frame (80) comprises:
a depressed portion (80R; 80F) protruding from the frame (80) toward the substrate (P) and on which the substrate (P) is located; and
a contact portion (82; 84) protruding from the depressed portion (80R; 80F) and inserted into the hole (13; 33), and
wherein a part of the contact portion (82; 84) is located on a rear surface of the substrate (P).

2. The display device (1) of claim 1, wherein the contact portion (82; 84) of the frame (80) is electrically connected to the substrate (P).

3. The display device (1) of claim 1 or 2, further comprising a clip (15; 16) located on the rear surface of the substrate (P) around the hole (13; 33),
wherein the clip (15; 16) comprises:
a body (151; 161) located between the part of the contact portion (82; 84) and the rear surface of the substrate (P); and
a leg (154, 155; 164, 165, 166) bent from one side of the body (151; 161) in the forward direction, inserted into the substrate (P), and electrically connected to the substrate (P).

4. The display device (1) of claim 3, wherein the clip (15; 16) further comprises an arm (152, 153; 162, 163) bent from the other side of the body (151; 161) so as to be inclined in the forward direction, the arm (152, 153; 162, 163) including an end (152a, 153a; 162a, 163a) stepped up from the body (151; 161), and
wherein the part of the contact portion (82; 84) is located on the end (152a, 153a; 162a, 163a) of the arm (152, 153; 162, 163).

5. The display device (1) of claim 4, wherein the arm (152, 153; 162, 163) comprises a pair of arms (152, 153; 162, 163) spaced apart from each other along the other side of the body (151; 161),
wherein the contact portion (82; 84) comprises:
a first part (821; 841) forming the part of the contact portion (82; 84); and
a second part (822; 842) connecting the first part (821; 841) to the depressed portion (80R; 80F) and inserted between the pair of arms (152, 153; 162, 163), and
wherein a gap between portions of the pair of arms (152, 153; 162, 163) adjacent to distal ends of the pair of arms (152, 153; 162, 163) gradually increases in a direction away from the other side of the body (151; 161).

6. The display device (1) of claim 1 or 2,
wherein the substrate (P) comprises a contact region (35) formed around the hole (33) and electrically connected to the part of the contact portion (84).

7. The display device (1) of claim 6, wherein the contact portion (84) further comprises a pressed portion (841c) protruding from the part of the contact portion (84) toward the contact region (35).

8. The display device (1) of claim 6 or 7, wherein the contact portion (84) comprises:
a first part (841) forming the part of the contact portion (84); and
a second part (842) connecting the first part (841) to the depressed portion (80F) and inserted into the hole (33),
wherein the hole (33) is formed to be elongated in a direction from the second part (842) toward the first part (841), and
wherein a width of the hole (33) adjacent to a distal end of the hole (33) gradually increases in a direction approaching the first part (841).

9. The display device (1) of any one of claims 1 to 8, wherein the contact portion (82; 84) comprises:
a first part (821; 841) comprising an inclined portion (821a; 841a) extending from the depressed portion (80R; 80F) so as to be inclined and a horizontal portion (821b; 841b) bent from the inclined portion (821a; 841a) in a direction parallel to the substrate (P); and
a second part (822; 842) extending from the horizontal portion (821b; 841b) toward the depressed portion (80R; 80F) so as to be inclined to be connected to the depressed portion (80R; 80F), and
wherein the second part (822; 842) has a width less than a width of the first part (821; 841).

10. The display device (1) of claim 9, wherein the hole (13; 33) comprises:
a first portion (131; 331) having a width corresponding to the width of the first part (821; 841) and into which the first part (821; 841) is inserted; and
a second portion (132; 332) having a width corresponding to the width of the second part (822; 842) and into which the second part (822; 842) is inserted, and
wherein the horizontal portion (821b; 841b) presses the rear surface of the substrate (P) around the second portion (132; 332) in the forward direction.

11. The display device (1) of any one of claims 1 to 10, wherein the depressed portion (80R; 80F) is formed by pressing a front surface of the frame (80) in a backward direction, and
wherein the contact portion (82; 84) is formed by pressing a front surface of the depressed portion (82; 84) in the backward direction.

12. The display device (1) of any one of claims 1 to 11, wherein the frame (80) comprises a hole (82h; 84h) formed at the depressed portion (80R; 80F) or the contact portion (82; 84) adjacent to a boundary between the depressed portion (80R; 80F) and the contact portion (82; 84).

13. The display device (1) of any one of claims 1 to 12, wherein the hole (13; 33) is formed to be elongated,
wherein the substrate (P) comprises a slot (14; 34) formed to be elongated in the same direction as the hole (13; 33) and spaced apart from the hole (13; 33), and
wherein the frame (80) further comprises a pin (82P; 84P) protruding from the depressed portion (80R; 80F) and movably inserted into the slot (14; 34).

14. The display device (1) of claim 13, wherein the frame (80) further comprises a protrusion (82S; 84S) protruding from the depressed portion (80R; 80F), inserted into the slot (14; 34), and spaced apart from the pin (82P; 84P), and
wherein the protrusion (82S; 84S) comprises:
a first surface (82S1; 84S1) facing the pin (82P; 84P) and inclined with respect to the depressed portion (80R; 80F); and
a second surface (82S2; 84S2) opposite the first surface (82S1; 84S1) and to which one end of the slot (14; 34) is hung.

15. The display device (1) of claim 13, or 14, wherein the substrate (P) further comprises an insertion hole (34h) spaced apart from the slot (34) in a longitudinal direction of the slot (34),
wherein the frame (80) further comprises a protrusion (84S) protruding from the depressed portion (80F) and inserted into the insertion hole (34h),
wherein the protrusion (84S) comprises:
a first surface (84S1) inclined with respect to the depressed portion (80F); and
a second surface (84S2) opposite the first surface (84S1) and to which the insertion hole (34h) is hung, and
wherein one end of the slot (34) is hung by the pin (84P).
